Europäisches Patentamt

European Patent Office

Office européen des brevets

(19)

(11) **EP 0 627 138 B1**

(12) **EUROPÄISCHE PATENTSCHRIFT**

(45) Veröffentlichungstag und Bekanntmachung des Hinweises auf die Patenterteilung:
**10.07.1996 Patentblatt 1996/28**

(21) Anmeldenummer: 93903821.2

(22) Anmeldetag: **18.02.1993**

(51) Int Cl.⁶: **H04H 1/00**, H03D 3/04

(86) Internationale Anmeldenummer:
**PCT/DE93/00158**

(87) Internationale Veröffentlichungsnummer:
**WO 93/17509 (02.09.1993 Gazette 1993/21)**

(54) **DEMODULATOR FÜR RADIO-DATEN-SIGNALE**

DEMODULATOR FOR RADIO DATA SIGNALS

DEMODULATEUR POUR SIGNAUX DE DONNEES RADIO

(84) Benannte Vertragsstaaten:
**AT CH ES FR GB IT LI NL SE**

(30) Priorität: **19.02.1992 DE 4205014
19.02.1992 DE 4205015
19.02.1992 DE 4205016
13.11.1992 DE 4238373**

(43) Veröffentlichungstag der Anmeldung:
**07.12.1994 Patentblatt 1994/49**

(73) Patentinhaber: **HENZE, Werner
D-30657 Hannover (DE)**

(72) Erfinder: **HENZE, Werner
D-30657 Hannover (DE)**

(74) Vertreter: **Gramm, Werner, Prof., Dipl.-Ing. et al
Patentanwälte Gramm + Lins
Theodor-Heuss-Strasse 1
38122 Braunschweig (DE)**

(56) Entgegenhaltungen:
**EP-A- 0 291 826          EP-A- 0 374 996**

• **SIEMENS COMPONENTS Bd. 25, Nr. 3, 1. Juli 1990, BERLIN Seiten 86 - 91 A. DIETZE 'SDA 1000 DECODES RADIO DATA SIGNALS'**
• **EUROPEAN BROADCASTING UNION REVIEW Nr. 204, 1. April 1984, Seiten 50 - 58 S. ELY ET. AL. 'DESIGN PRINCIPLES FOR VHF/FM RADIO RECEIVERS USING THE EBU RADIO-DATA SYSTEM RDS'**

## Beschreibung

Die Erfindung betrifft einen Demodulator für Radio-Daten-Signale nach der Gattung des Patentanspruchs 1.

Mit dem bekannten Radio-Daten-System können zusätzlich zu den Audiosignalen Datensignale übertragen werden, die beispielsweise den Namen des ausgestrahlten Programms oder andere Information enthalten. Um beim UKW-Stereo-Hörrundfunk die Kompatibilität mit den Audiosignalen sowie mit Verkehrsfunksignalen sicherzustellen, wird bei dem Radio-Daten-System der auch beim Verkehrsfunk verwendete Träger von 57 kHz mit den zu übertragenden Daten moduliert, wobei allerdings die Seitenbänder außerhalb der für verschiedene Signale des Verkehrsfunks benutzten Modulationsfrequenzen liegen. Es wird dabei eine Biphase-Codierung gewählt, die bewirkt, daß sich keine Spektralanteile bei 57 kHz ergeben und der Takt implizit mitübertragen wird. Das gesamte Spektrum des modulierten Radio-Daten-Signals, im folgenden auch RDS-Signal genannt, wird auf ±2,4 kHz begrenzt.

Herkömmliche RDS-Decoder beruhen auf der Verwendung von Phasenregelschleifen. In Funkschau, Heft 7/1988, Seite 42, ist ein RDS-Decoder beschrieben, dem das 57 kHz-Signal verstärkt und amplitudenbegrenzt, also als Rechtecksignal, zugeführt wird. Die RDS-Information wird in einem Synchron-Demodulator mit Trägerrückgewinnung (Costas Loop) demoduliert.

Der vorliegenden Erfindung liegt die Aufgabe zugrunde, einen Demodulator für RDS-Signale anzugeben, bei dem keine Einschwingzeiten von Phasenregelschleifen auftreten.

Diese Aufgabe wird erfindungsgemäß mit einem Demodulator mit den Merkmalen des Patentanspruchs 1 gelöst.

Der erfindungsgemäße Demodulator hat den Vorteil, daß er nur digitale Bauelemente enthalten kann, wodurch eine preiswerte Realisierung als integrierter Schaltkreis möglich ist und bei der Herstellung keine teuren Abgleicharbeiten erforderlich sind.

Eine Realisierung des erfindungsgemäßen Demodulators ist ferner durch geeignete Programme für Signalprozessoren oder andere mikroelektronische Bauelemente möglich. Da der erfindungsgemäße Demodulator besonders schnell arbeiten kann, kann er beispielsweise mit Vorteil in einem Rundfunkempfänger verwendet werden, bei dem (z. B. gemäß DE 41 03 062 A1) kurzzeitig eine Prüfung auf alternative Frequenzen erfolgt, ohne daß der Empfang des jeweils eingestellten Senders störend beeinträchtigt wird.

Für die Erzeugung des zweiten Rechtecksignals wird in einer Ausführungsform der Erfindung ein etwa hilfträgerfrequentes Signal erzeugt, dessen Phase von Zeit zu Zeit an die Phase des empfangenen RDS-Signals angepaßt wird. In einer anderen Ausführungsform wird das zweite Signal durch eine Verzögerung des ersten Signals um eine halbe RDS-Datenperiode gebildet.

Vorteilhafte Ausbildungen der Erfindung sind in den Unteransprüchen aufgeführt und anhand von Ausführungsbeispielen mit ihren Eigenschaften und Vorteilen anhand der Zeichnung näher erläutert. Es zeigen:

| | |
|---|---|
| Figur 1 | ein Bockschaltbild eines Demodulators nach einem ersten Ausführungsbeispiel |
| Figur 2 | ein Blockschaltbild eines ersten in dem Demodulator nach Figur 1 enthaltenen Impulsformers |
| Figur 3 | ein Blockschaltbild einer in dem Demodulator nach Figur 1 enthaltenen Torschaltung |
| Figur 4 und Figur 5 | in dem Demodulator nach Figur 1 verwendete Auswerteschaltungen |
| Figur 6 | weitere in dem Demodulator nach Figur 1 enthaltene Auswerteschaltungen und |
| Figur 7 | ein Ausführungsbeispiel für eine in dem Demodulator nach Figur 1 verwendete Logikschaltung |
| Figur 8 | ein Blockschaltbild eines Demodulators nach einem zweiten Ausführungsbeispiel |
| Figur 9 | ein Blockschaltbild eines in dem Demodulator nach Figur 8 enthaltenen Impulsformers |
| Figur 10 | eine schematische Darstellung der RDS-Signalvektoren in verschiedenen, bei dem Demodulator nach Figur 8 auftretenen Signalen |
| Figur 11 | ein Blockschaltbild einer in dem Demodulator nach Figur 8 enthaltenen Schaltung zur Datentaktgewinnung |
| Figur 12 | Zeitdiagramme von Signalen, die bei der Schaltungsanordnung nach Figur 11 auftreten |

# EP 0 627 138 B1

| Figur 13 | ein Blockschaltbild eines Demodulators nach einem dritten Ausführungsbeispiel |
|---|---|
| Figur 14 | Zeitdiagramme von in dem Demodulator nach Figur 13 auftretenen Signalen |
| Figur 15 | eine Schaltungsanordnung zur Durchführung einer vektoriellen Addition, wie sie in Figur 13 angedeutet ist |
| Figur 16 | Zeitdiagramme von Signalen, die bei der Schaltungsanordnung nach Figur 15 auftreten |
| Figur 17 | ein Blockschaltbild eines Trägerregenerators |
| Figur 18 | ein Blockschaltbild einer Schaltung zur Synchronimpulserzeugung, die Teil des Trägerregenerators nach Figur 17 ist |
| Figur 19 | ein Blockschaltbild einer Schaltung zur Gewinnung einer doppelten Bit-Taktfrequenz |
| Figur 20 bis 22 | Blockschaltbilder von Teilen der Schaltung nach Figur 19. |

In den Figuren sind Zähler durch ein Symbol "0, 1, 2...", Speicher durch "MEM" und Schieberegister mit "SR" gekennzeichnet. Dabei bedeutet "CL" Takteingang, "R" Rücksetzeingang, "D" Dateneingang und "LD" Load-Eingang. Bei Komparatoren sind die Eingangsgrößen mit X und Y bezeichnet und die Ausgänge mit der jeweiligen Bedingung. Decoder, welche eine vom Inhalt eines Zählers abhängige Information erzeugen, sind durch den jeweiligen Zählerstand in eckigen Klammern gekennzeichnet. Einige Ein- und Ausgänge sind mit Pfeilen und Ziffern versehen, die darauf hinweisen, von und zu welchen Teilen die entsprechenden Signale geleitet werden.

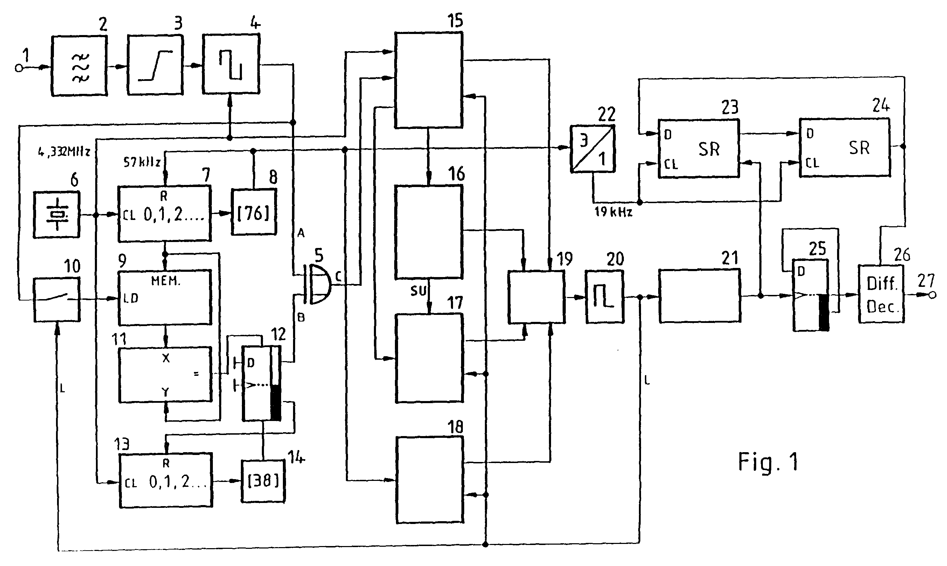

Dem in Figur 1 dargestellten Demodulator wird bei 1 das empfangene Multiplexsignal zugeführt. In einem Bandpaß 2 wird aus dem Multiplexsignal das RDS-Signal gewonnen, dessen Amplitude in einem anschließenden Begrenzer 3 begrenzt wird. In einem Impulsformer 4 wird aus dem begrenzten RDS-Signal ein Rechtecksignal mit einem Tastverhältnis von 50 % erzeugt, das die Phasenmodulation des RDS-Signals enthält und im folgenden Signal A genannt wird. Dieses wird in einer Logikschaltung 5 mit einem Signal B kombiniert, welches ebenfalls mäanderförmig ist, eine Frequenz von 57 kHz aufweist und in seiner Phasenlage zu bestimmten Zeitpunkten an die Phase des Signals A angepaßt wird.

Zur Erzeugung eines 57-kHz-Taktsignals dient ein Quarzoszillator 6 mit einer Frequenz von 4,332 MHz, welche mit einem ersten Zähler 7 und einem ersten Decoder 8 durch 76 geteilt wird. Sobald der erste Zähler 7, dem das Ausgangssignal des Quarzoszillators 6 als Takt zugeführt wird, bis 76 gezählt hat, wird dieses vom Decoder 8 erkannt und der Zähler zurückgesetzt.

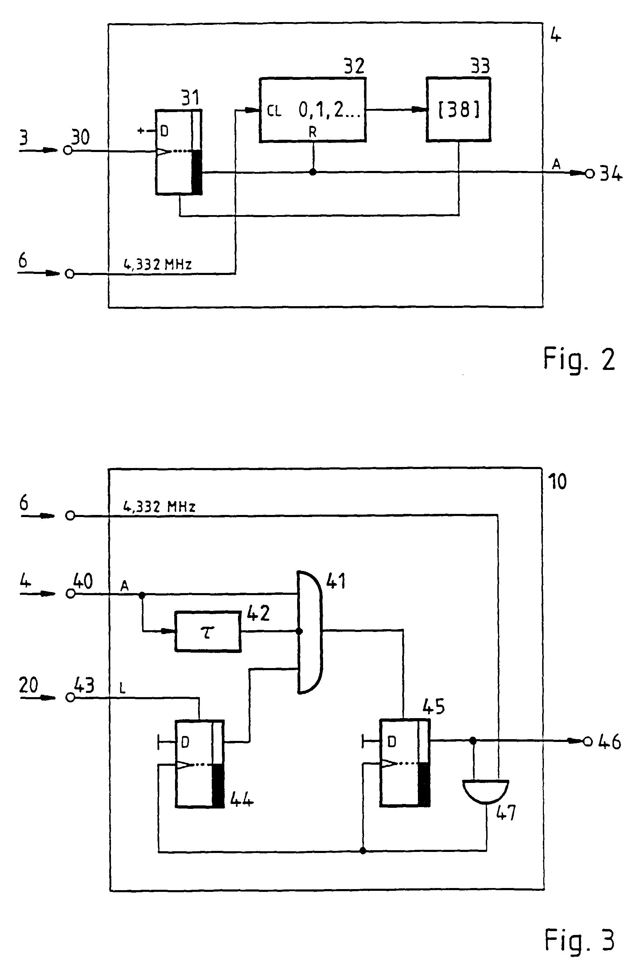

Zur Erzeugung des Signals B wird der Zählerstand des ersten Zählers 7 in einen Speicher 9 zum Zeitpunkt einer Flanke des Signals A geladen, die durch einen Ladeimpuls L ausgewählt wird. Dazu wird das Signal A über eine Torschaltung 10 dem Ladeeingang des Speichers 9 zugeführt. Die Torschaltung 10 wird im einzelnen anhand von Figur 3 später beschrieben.

Der Inhalt des Speichers 9 wird in einem Komparator 11 mit dem jeweiligen Inhalt des ersten Zählers 7 verglichen. Bei Übereinstimmung beider Werte wird ein Flip-Flop 12 gesetzt, an dessen Ausgang das Signal B ansteht. Durch das Setzen entsteht die Vorderflanke des Signals B. Die Rückflanke des Signals B wird mit Hilfe eines zweiten Zählers 13 und eines zweiten Decoders 14 erzeugt. Dazu wird der zweite Zähler mit dem 4,332-MHz-Takt getaktet und durch das Setzen des Flip-Flops 12 zurückgesetzt. Hat der Zähler die halbe Periodendauer des Signals B erreicht, was beim Zählerstand 38 der Fall ist, wird vom zweiten Decoder 14 das Flip-Flop zurückgesetzt.

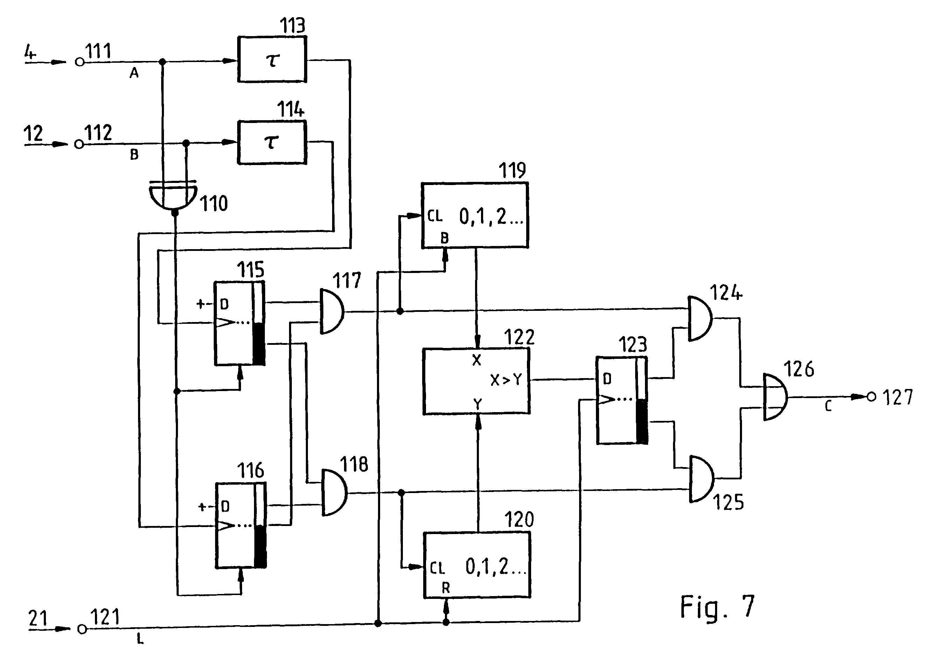

Die Logikschaltung 5 entspricht im wesentlichen einer Exklusiv-Oder-Schaltung. Ein aufwendigeres Ausführungsbeispiels ist im Zusammenhang mit Figur 7 später beschrieben. Das Ausgangssignal der Logikschaltung 5 nimmt demnach einen ersten logischen Pegel ein, wenn die Signale A und B verschieden sind, während der andere logische Pegel bei Gleichheit der Signale A und B vorliegt. Das derart kombinierte Signal C gibt somit die Phasendifferenzen zwischen den Signalen A und B an. Anhand dieser Phasendifferenzen wird in vier Auswerteschaltungen geprüft, ob vier verschiedene Bedingungen erfüllt sind.

Wird ein RDS-Signal ohne Verkehrsfunksignal empfangen, dann wird die Impulsbreite des Signals C, bezogen auf den Zeitpunkt des zum Beispiel positiven maximalen Phasenhubes, kleiner, wenn der Zeitpunkt des negativen maximalen Phasenhubes überschritten wird.

Wenn ein RDS-Signal mit Verkehrsfunksignalen empfangen wird, wird die Impulsbreite des Signals C kleiner, wenn der Hilfsträger seine maximale Phasenauslenkung gegenüber seiner Nullphase aufweist.

Wie nachfolgend noch beschrieben wird, wird im ersten Fall nach Überschreitung des maximalen Phasenhubes und im zweiten Fall bei jeder maximalen Phasenauslenkung des Hilfsträgers ein Ladeimpuls erzeugt.

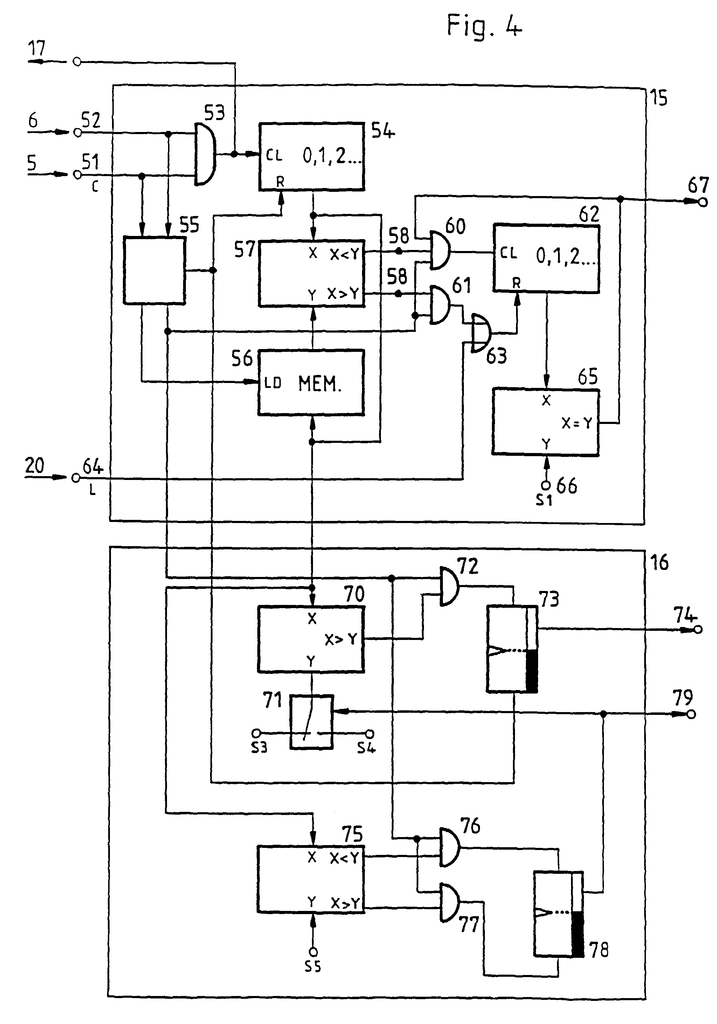

Die Auswerteschaltung 15 erhält dazu neben dem Signal C das 4,332-MHz-Taktsignal und den Ladeimpuls L, der aus den Ausgangssignalen der Auswerteschaltungen 15 bis 18 mit Hilfe einer weiteren Logikschaltung 19 abgeleitet wird. Wie später im Zusammenhang mit Figur 4 näher beschrieben wird, prüft die Auswerteschaltung 15, ob die Impulsbreite des Signals C kontinuierlich kleiner wird. Ein entsprechendes Ausgangssignal wird der weiteren Logikschaltung 19 zugeführt.

Zur Messung der Impulsbreite des Signals C ist in der Auswerteschaltung 15 ein Zähler vorhanden, mit welchem Impulse des 4,332-MHz-Taktsignals während der Dauer jeweils eines Impulses des Signals C gezählt werden. Der Zählerstand am Ende des Impulses des Signals C entspricht demnach der Impulsbreite. Dieser Zählerstand wird von der Auswerteschaltung 15 zur Auswerteschaltung 16 weitergeleitet. Dort wird die Bedingung überprüft, ob die Phasenabweichung einen vorgegebenen Schwellwert überschritten hat. Ist dieses der Fall, wird ein entsprechendes Signal an die weitere Logikschaltung 19 gegeben. Außerdem erzeugt die Auswerteschaltung 16 ein Schwellwertumschaltsignal, das der Auswerteschaltung 17 zugeführt wird, mit deren Hilfe geprüft wird, ob die Summe aller Taktimpulse aller ausgezählten Impulse des Signals C einen vorgegebenen Schwellwert überschritten hat. Zutreffendenfalls wird ebenfalls ein Signal an die weitere Logikschaltung 19 gegeben. Schließlich wird in einer Auswerteschaltung 18 ein Signal erzeugt und der weiteren Logikschaltung 19 zugeführt, welches besagt, ob nach einer positiven Flanke des Taktsignals (57 kHz) eine Mindestzeit vergangen ist.

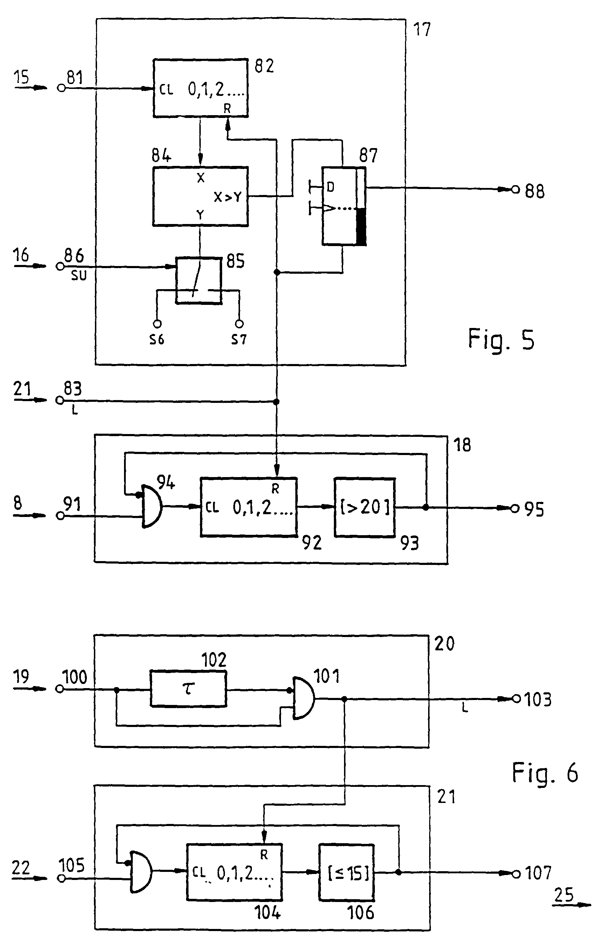

Aus dem Ausgangssignal der weiteren Logikschaltung 19 wird in einem weiteren Impulsformer 20 der Ladeimpuls L erzeugt. Dieser wird einerseits der Torschaltung 10 und andererseits einer Schaltung 21 zur Erkennung von Impulslücken zugeführt, die in Figur 6 genauer dargestellt ist. Mit der Schaltung 21 wird festgestellt, ob sich die Phase des Empfangssignals innerhalb einer halben oder einer Bittaktperiode geändert hat. Das heißt, es wird ermittelt, ob etwa nach einer halben Bittaktperiode ein Ladeimpuls vorhanden ist oder nicht. Wenn kein Ladeimpuls vorhanden ist, wird ein Datentakt ausgegeben.

Ein Bittaktsignal wird aus dem 57-kHz-Taktsignal mit Hilfe eines Frequenzteilers 22 und zweier Schieberegister 23,24 abgeleitet. Der Frequenzteiler 22 erzeugt zunächst ein 19-kHz-Signal, das die Schieberegister 23,24 taktet. Das Schieberegister 23 wird bei jedem von der Schaltung 21 erzeugten Datenimpulssignal auf binär 1000 0000 geladen und das Schieberegister 24 auf 0 gesetzt. Bei einem Schiebetakt von 19 kHz fallen in eine RDS-Bittaktperiode 16 Schiebetakte. Nach acht Schiebetakten ist die Mitte des Datensignals erreicht, das heißt, die ins Schieberegister 23 geladene "1" ist dann am Ausgang des Schieberegisters 24 angelangt. Solange kein Datentaktimpuls vorkommt, wird die geladene "1" im Kreis durch die Schieberegister 23,24 geschoben. Am Ausgang des Schieberegisters 24 erscheint sie jeweils im Abstand einer RDS-Bittaktperiode. Der Vorteil der Schaltung besteht darin, daß der Bittakt bei jedem Datentakt neu synchronisiert wird.

Das Datenimpulssignal triggert ein Flip-Flop 25, so daß Impulse entstehen, welche jeweils bei einem Impuls des Datenimpulssignals von einem Pegel in den anderen übergehen. Dieses Signal entspricht an sich dem RDS-Signal, wobei allerdings die senderseitig erfolgte Differenzcodierung noch enthalten ist. Diese wird mit Hilfe einer an sich bekannten Schaltung 26 decodiert, so daß am Ausgang 27 das demodulierte RDS-Signal ansteht.

Da die Auserteschaltungen 15 bis 18 die Vorder- und Rückflanken des Signals A gleichermaßen auswerten, ist die Einhaltung eines konstanten Tastverhältnisses besonders wichtig, was jedoch bei dem lediglich begrenzten modulierten RDS-Signal am Ausgang des Begrenzers 3 nicht gegeben ist. Deshalb wird im Impulsformer 4 ein Signal mit einem Tastverhältnis von 50 % erzeugt. Dazu wird im Impulsformer 4, von dem in Figur 2 ein vorteilhaftes Ausführungsbeispiel dargestellt ist, das Ausgangssignal des Begrenzers 3 dem Takteingang eines Flip-Flops 31 zugeführt, dessen Dateneingang mit positiver Spannung beaufschlagt ist. Durch die Vorderflanke des begrenzten modulierten RDS-Signals wird das Flip-Flop 31 gesetzt. Der invertierende Ausgang des Flip-Flops 31 ist mit dem Rücksetzeingang eines Zählers 32 verbunden, der vom 4,332-MHz-Taktsignal getaktet wird.

Sobald das Flip-Flop 31 gesetzt ist, beginnt der Zähler 32 zu zählen. Mit Hilfe eines Decoders 33 wird der Zähler 32 beim Zählerstand 38 durch Rücksetzen des Flip-Flops 31 ebenfalls zurückgesetzt. Wegen des Frequenzverhältnisses des 4,332-MHz-Takts zur Trägerfrequenz von 57 kHz des RDS-Signals von 76:1 ist beim Zählerstand 38 die halbe Periodendauer abgelaufen. Das Tastverhältnis des Signals am Ausgang 34 beträgt deshalb 50 %.

Figur 3 ist ein Blockschaltbild der Torschaltung 10 (Figur 1). Aus dem Signal A wird mit Hilfe einer Und-Schaltung 41, deren eines Eingangssignal invertiert ist, und einer Verzögerungsschaltung 42 ein kurzer Impuls erzeugt, welcher den Vorderflanken des Signals A entspricht, das dem Eingang 40 zugeführt wird. Die verzögerungsschaltung 42 kann in einfacher Weise durch Logikelemente, beispielsweise in Reihe geschaltete Invertierer, verwirklicht werden. Der einem Eingang 43 zugeführte Ladeimpuls L setzt ein Flip-Flop 44, dessen Ausgang mit einem weiteren Eingang der Und-Schaltung verbunden ist. Ein weiteres Flip-Flop 45 kann nur zu einem Zeitpunkt gesetzt werden, zu dem einerseits das Flip-Flop 44 gesetzt ist und zu dem der von der Vorderflanke des Signals A abgeleitete Impuls gleich 1 ist. Sobald das weitere Flip-Flop 45 gesetzt ist, wird über den Ausgang 46 der Speicher 9 (Figur 1) geladen.

Nach dem Setzen des weiteren Flip-Flops 45 werden beide Flip-Flops 44, 45 wieder zurückgesetzt, wenn das 4,332-MHz-Taktsignal gleich 0 ist. Dazu wird das 4,332-MHz-Taktsignal über eine Und-Schaltung 47 den Takteingängen der Flip-Flops 44,45 zugeführt.

Figur 4 stellt Blockschaltbilder der Auswerteschaltungen 15 und 16 dar. Der Auswerteschaltung 15 wird über einen Eingang 51 das Signal C zugeführt. Ferner erhält die Auswerteschaltung 15 über einen weiteren Eingang 52 das 4,332-MHz-Taktsignal. Beide Signale werden über eine Und-Schaltung 53 einem Zähler 54 zugeleitet, der somit nur während der Phasendifferenzen zwischen den Signalen A und B getaktet wird. Das Signal C und das 4,332-MHz-Taktsignal werden ferner einer Schaltung 55 zur Impulssteuerung zugeführt, welche ein Rücksetzsignal für den Zähler 54, ein Ladesignal für einen Speicher 56 und weitere Signale erzeugt, welche die im folgenden beschriebene Funktion zeitlich steuern. Nach jedem Impuls des Signals C wird der Zählerstand des Zählers 54 in den Speicher 56 eingeschrieben. Zuvor wird jedoch in einem Komparator 57 der Zählerstand am Ende des Impulses des Signals C mit dem Inhalt des Speichers 56 verglichen.

Der Komparator 57 weist zwei Ausgänge auf, an denen Signale anstehen, die angeben, ob das Signal am Eingang X größer als das Signal am Eingang Y bzw. das Signal am Eingang X kleiner als das Signal am Eingang Y ist. Beide Ausgänge 58,59 sind mit Und-Schaltungen 60,61 verbunden. Der Ausgang der Und-Schaltung 60 ist an den Takteingang eines weiteren Zählers 62 angeschlossen, während der Ausgang der Und-Schaltung 61 über eine Oder-Schaltung 63 mit dem Rücksetzeingang des Zählers 62 verbunden ist.

Der Oder-Schaltung 63 wird über einen Eingang 64 der Ladeimpuls L zugeführt. Der Zählerstand des Zählers 62 wird in einem weiteren Komparator 65 mit einem bei 66 zugeführten Schwellwert S1 verglichen. Der Ausgang des Komparators 65 führt ein Signal bei Übereinstimmung beider zugeführten Signale, das die Erfüllung der Bedingung angibt und am Ausgang 67 der Auswerteschaltung 15 entnehmbar ist.

Ist von einem Impuls des Signals C zum folgenden die Impulsbreite kleiner geworden, so wird mit Hilfe des Komparators 57 über den Ausgang 58 und die Und-Schaltung 60 der Zähler 62 inkrementiert. Ist jedoch die Impulsbreite größer geworden, wird der Zähler 62 über den Ausgang 59 des Komparators 57, die Und-Schaltung 61 und die Oder-Schaltung 63 zurückgesetzt. Ein Ansteigen des Zählerstandes (Zähler 62) auf den bei 66 zugeführten Schwellwert S1 erfolgt dementsprechend nur, wenn die Impulsbreite während einer durch S1 vorgegebenen Anzahl von Perioden des Signals C ununterbrochen kleiner ist.

Die ebenfalls in Figur 4 dargestellte Auswerteschaltung 16 prüft, ob die zweite Bedingung erfüllt ist, nämlich ob die Impulsbreite des Signals C den vorgegebenen Wert überschritten hat. Dazu wird der Inhalt des Speichers 56 in einem Komparator 70 mit einem Schwellwert S3 oder einem Schwellwert S4 verglichen, die alternativ über einen steuerbaren Umschalter 71 dem Y Eingang des Komparators 70 zugeführt werden. Ist der die Impulsbreite darstellende Inhalt des Speichers 56 größer als der jeweilige Schwellwert S3 oder S4, wird über eine Und-Schaltung 72 ein Flip-Flop 73 gesetzt, an dessen Ausgang 74 ein die Erfüllung der zweiten Bedingung kennzeichnendes Signal abnehmbar ist. Das Flip-Flop wird durch ein von der Impulssteuerschaltung 55 erzeugtes Rücksetzsignal nach dem Ende des Impulses des Signals C wieder zurückgesetzt.

Die Auswahl des Schwellwertes für den Komparator 70 erfolgt im Hinblick darauf, ob im empfangenen Signal außer dem RDS-Signal noch ein verkehrsfunksignal enthalten ist. In diesem Fall ist mit einer kleineren maximalen Phasendifferenz zwischen den Signalen A und B zu rechnen, so daß die Schwelle heruntergesetzt wird. Um dieses erfassen zu können, ist ein weiterer Komparator 75 vorgesehen, dem ein Schwellwert S5 zugeführt wird und der über Und-Schaltungen 76,77 ein Flip-Flop 78 in Abhängigkeit davon setzt oder zurücksetzt, ob die Impulsbreite größer oder kleiner als der Schwellwert S5 ist. Das Ausgangssignal SU des Flip-Flops 78 wird einerseits zur Steuerung des Umschalters 71 benutzt und andererseits über einen Ausgang 79 der in Figur 5 dargestellten Auswerteschaltung 17 zur Verfügung gestellt.

Figur 5 zeigt die beiden Auswerteschaltungen 17 und 18 (Figur 1), wobei die Auswerteschaltung 17 prüft, ob die Summe der Impulsbreiten aller Impulse des C-Signals, gerechnet vom letzten Ladeimpuls, einen Schwellwert überschritten hat. Dazu wird einem Eingang 81 das Ausgangssignal der Und-Schaltung 53 (Figur 4) als Taktsignal für einen Zähler 82 zugeführt. Der Zähler 82 wird durch den Ladeimpuls L, der einem Eingang 83 zugeführt wird, zurückgesetzt. Dadurch enthält der Zähler jeweils die Anzahl der seit dem letzten Ladeimpuls während der Impulse des Signals C aufgetretenen Impulse des 4,332-MHz-Taktsignals. Dieses entspricht der Summe aller Impulsbreiten.

Zum Vergleich mit einem Schwellwert ist ein Komparator 84 vorgesehen, welchem über einen steuerbaren Umschalter 85 alternativ ein Schwellwert S6 oder ein Schwellwert S7 zuführbar ist. Der steuerbare Umschalter 85 ist mit Hilfe des Signals SU umschaltbar, das dem Ausgang 79 der Auswerteschaltung 16 (Figur 4) entnehmbar und über einen Eingang 86 zuführbar ist. Sobald der Zählerstand des Zählers 82 größer als der jeweilige Schwellwert ist, wird ein Flip-Flop 87 gesetzt, an dessen Ausgang 88 ein der dritten Bedingung entsprechendes Signal entnehmbar ist. Das Flip-Flop 87 wird durch den Ladeimpuls L wieder zurückgesetzt.

In der ebenfalls in Figur 5 dargestellten Auswerteschaltung 18 wird geprüft, ob, ab dem letzten Ladeimpuls gerechnet, eine bestimmte vorgegebene Zeit vergangen ist. Diese wird durch Zählen von bei 91 zugeführten 57-kHz-Impulsen mit Hilfe eines Zähler 92 und eines Decoders 93 festgestellt. Der Zähler 92 wird durch den Ladeimpuls L zurückgesetzt. Solange der Zählerstand kleiner gleich 20 ist, wird vom Decoder 93 der logische Pegel 0 abgegeben. Dieses führt dazu, daß die Und-Schaltung 94 mit einem invertierenden Eingang die Zählimpulse zum Takteingang des Zählers 92 weiterleitet. Sobald der Zählerstand 24 überschritten ist, springt das Ausgangssignal des Decoders auf den logischen Pegel 1, worauf die Und-Schaltung 94 weiteres Zählen unterbricht. Damit nimmt auch das Signal am Ausgang 95 der Auswerteschlatung 18 den Wert 1 an, wodurch angezeigt ist, daß seit dem letzten Ladeimpuls eine bestimmte vorgegebene Zeit vergangen ist. Damit wird ausgeschlossen, daß nach Erfüllung der ersten drei Bedingungen ein Ladeimpuls vorzeitig generiert wird.

Nachdem in der weiteren Logikschaltung 19 (Figur 1) überprüft worden ist, ob die vier genannten Bedingungen erfüllt sind, wird aus dem Ausgangssignal der weiteren Logikschaltung 19 im Impulsformer 20 der Ladeimpuls L erzeugt. Dieses erfolgt gemäß Figur 6 in einfacher Weise dadurch, daß das Ausgangssignal der weiteren Logikschaltung 19 in dem Impulsformer 20 über einen Eingang 100 einem ersten Eingang einer Und-Schaltung 101 direkt und einem invertierenden, zweiten Eingang der Und-Schaltung 101 über ein verzögerungsglied 102 zugeführt wird. Das verzögerungsglied 102 kann in einfacher Weise durch Logikschaltungen verwirklicht werden und bestimmt die Impulsdauer des am Ausgang 103 anstehenden Ladeimpulses L.

Zur Erzeugung des Datenimpulssignals wird der Ladeimpuls der Schaltung 21 zugeführt, welche ebenfalls in Figur 6 dargestellt ist. Dort dient der Ladeimpuls L zum Zurücksetzen eines Zählers 104, der von einem 19-kHz-Taktsignal, das einem Eingang 105 vom Frequenzteiler 22 (Figur 1) zuführbar ist, getaktet wird. Wird ein durch einen Decoder 106 vorgegebener Schwellwert überschritten, wird die Zählung gestoppt und das an den Ausgang 107 der Schaltung 21 angeschlossene Flip-Flop 25 (Figur 1) gekippt. Damit liefert das Flip-Flop 25 das bereits demodulierte RDS-Signal, allerdings ohne eine Differenz-Decodierung.

Figur 7 zeigt ein Ausführungsbeispiel für die Logikschlatung 5 (Figur 1), mit der festgestellt wird, welche der beiden möglichen Phasenlagen der Signale A und B zueinander zwischen zwei Ladeimpulsen überwiegt. Eine dementsprechende voreinstellung für die zu erwartende Phasenlage wird mit dem Flip-Flop 123 vorgenommen. Die Störfestigkeit des Demodulators wird dadurch verbessert.

Die Signale A und B werden über Eingänge 111 und 112 je einer verzögerungsschaltung 113,114 zugeführt. Mit den verzögerten Signalen A und B werden Flip-Flops 115,116 getaktet und wegen positiver Spannung am Dateneingang dadurch auch gesetzt. Ein Zurücksetzen der Flip-Flops 115,116 erfolgt mit dem Ausgangssignal der Nicht-Exklusiv-Oder-Schaltung 110.

Sind die Signale A und B ungleich, können dementsprechend die Flip-Flops gesetzt werden, während bei gleichen Signalen die Flip-Flops 115,116 rückgesetzt werden. Die Ausgänge der Flip-Flops 115 und 116 sind über Und-Schaltungen 117,118 mit Takteingängen von Zählern 119,120 verbunden, die vom bei 121 zugeführten Ladeimpuls L zurückgesetzt werden. Mit Hilfe der Und-Schaltungen 117 und 118 kann jeweils nur das Ausgangssignal desjenigen Flip-Flops 115 bzw. 116 zum jeweiligen Zähler 119 bzw. 120 gelangen, welches zuerst gesetzt wird.

Zum Zeitpunkt des Ladeimpulses wird einer der Zähler 119,120 einen größeren Wert enthalten als der andere Zähler. Dieses wird mit Hilfe eines Komparators 122 festgestellt. In Abhängigkeit vom Vergleichsergebnis wird ein Flip-Flop 123 gesetzt, das vom Ladeimpuls L getaktet wird. Durch Zurücksetzen der Zähler 119 und 120 können die Zählungen neu beginnen. Die Ausgänge der Und-Schaltungen 117,118 sind mit jeweils einem Eingang weiterer Und-Schaltungen 124,125 verbunden, deren weitere Eingänge an die Ausgänge des Flip-Flops 123 angeschlossen sind.

Die Vorauswahl der Impulse an den Ausgängen der Und-Schaltungen 117 und 118 wird mit Hilfe des Flip-Flops 123 und der Und-Schaltungen 124 und 125 getroffen. Über die Oder-Schaltung 126 ergeben die jeweils ausgewählten Impulse des Signal C, die dem Ausgang 127 entnommen werden können.

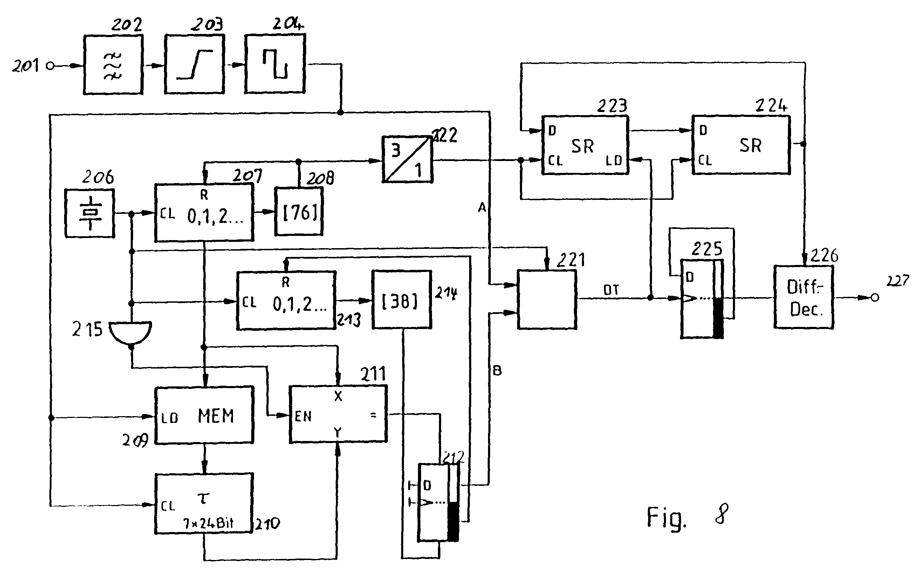

Dem in Figur 8 dargestellten Demodulator gemäß einem zweiten Ausführungsbeispiel wird bei 201 das empfangene Multiplexsignal zugeführt. In einem Bandpaß 202 wird aus dem Multiplexsignal das RDS-Signal gewonnen, dessen Amplitude in einem anschließenden Begrenzer 203 begrenzt wird. In einem Impulsformer 204 wird aus dem begrenzten RDS-Signal ein Rechtecksignal mit einem Tastverhältnis von 50 % erzeugt, das die Phasenmodulation des RDS-Signals enthält und im folgenden Signal A genannt wird.

Zur Erzeugung eines 57-kHz-Taktsignals dient ein Quarzoszillator 206 mit einer Frequenz von 4,332 MHz, welche mit einem ersten Zähler 207 und einem ersten Decoder 208 durch 76 geteilt wird. Sobald der erste Zähler 207, dem das Ausgangssignal des Quarzoszillators 206 als Takt zugeführt wird, bis 76 gezählt hat, wird dieses vom Decoder 208 erkannt und der Zähler zurückgesetzt.

Mit Hilfe der Schaltungen 209 bis 215 wird das Signal A um eine halbe Periode des RDS-Bittaktes verzögert. Dabei wird die Phasenlage des Signals A auch im verzögerten Signal genau eingehalten. Das verzögerte Signal wird im folgenden Signal B genannt. Mit jeder positiven Flanke des Signals A wird der Zählerstand des Zählers 207, der 7 Bit umfaßt, in einen Speicher 209 übernommen. Damit steht der Phasenunterschied zwischen dem mit Hilfe des Zählers 207 und des Decoders 208 erzeugten 57-kHz-Taktsignal und dem Signal A für die jeweilige Flanke des Signals A fest. Dieser Phasenunterschied wird mit Hilfe einer verzögerungsschaltung 210 um eine halbe Bittaktperiode verzögert, was in vorteilhafter Weise mit sieben Schieberegistern mit jeweils einer Länge von 24 Bit erfolgt.

Die in den Speicher 209 geladenen Zählerstände werden mit Flanken des Signals A bis zum Ausgang der Schieberegister geschoben. Mit dem Komparator 211 wird das 7 Bit breite Ausgangssignal der Schieberegister mit dem Zählerstand des Zählers 207 verglichen. Das Ausgangssignal des Komparators wird freigegeben, wenn der Zähler 207 nicht inkrementiert wird, wozu das 4,332-MHz-Taktsignal über einen Invertierer 15 einem Enable-Eingang EN des Komparators zugeführt wird.

Sind das Ausgangssignal der verzögerungsschaltung 210 und der Zählerstand gleich, wird ein Flip-Flop 212 gestzt und der Zähler 213 freigegeben, womit ein Impuls des Signals B beginnt. Hat der Zähler 213 den Zählerstand 38 erreicht, setzt ein Decoder 214 das Flip-Flop 212 wieder zurück, wodurch der jeweilige "1"-Pegel des Signals B beendet und der Zähler 213 zurückgesetzt wird.

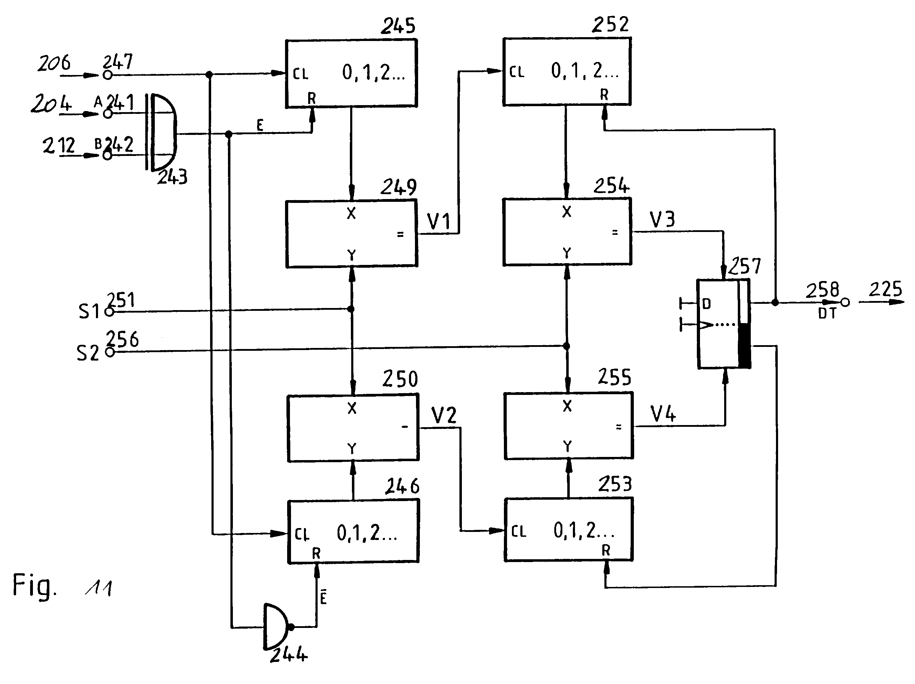

Aus den Signalen A und B wird in einer Schaltung 221, die später anhand der Figuren 10 bis 11 näher erläutert wird, der RDS-Datentakt DT gewonnen.

Ein Bittaktsignal wird aus dem 57-kHz-Taktsignal mit Hilfe eines Frequenzteilers 222 und zweier Schieberegister 223,224 abgeleitet. Der Frequenzteiler 222 erzeugt zunächst ein 19-kHz-Signal, das die Schieberegister 223,223 taktet. Das Schieberegister 223 wird bei jedem von der Schaltung 221 erzeugten Datenimpulssignal auf binär 1000 0000 geladen und das Schieberegister 224 auf 0 gesetzt. Bei einem Schiebetakt von 19 kHz fallen in eine RDS-Bittaktperiode 16 Schiebetakte. Nach acht Schiebetakten ist die Mitte des Datensignals erreicht, das heißt, die ins Schieberegister 223 geladene "1" ist dann am Ausgang des Schieberegisters 224 angelangt. Solange kein Datentaktimpuls vorkommt, wird die geladene "1" im Kreis durch die Schieberegister 223,224 geschoben. Am Ausgang des Schieberegisters 224 erscheint sie jeweils im Abstand einer RDS-Bittaktperiode. Der Vorteil der Schaltung besteht darin, daß der Bittakt bei jedem Datentakt neu synchronisiert wird.

Das Datenimpussignal triggert ein Flip-Flop 225, so daß Impulse entstehen, welche jeweils bei einem Impuls des Datenimpulssignals von einem Pegel in den anderen übergehen. Dieses Signal entspricht an sich dem RDS-Signal, wobei allerdings die senderseitig erfolgte Differenzcodierung noch enthalten ist. Diese wird mit Hilfe einer an sich bekannten Schaltung 226 decodiert, so daß am Ausgang 227 das demodulierte RDS-Signal ansteht.

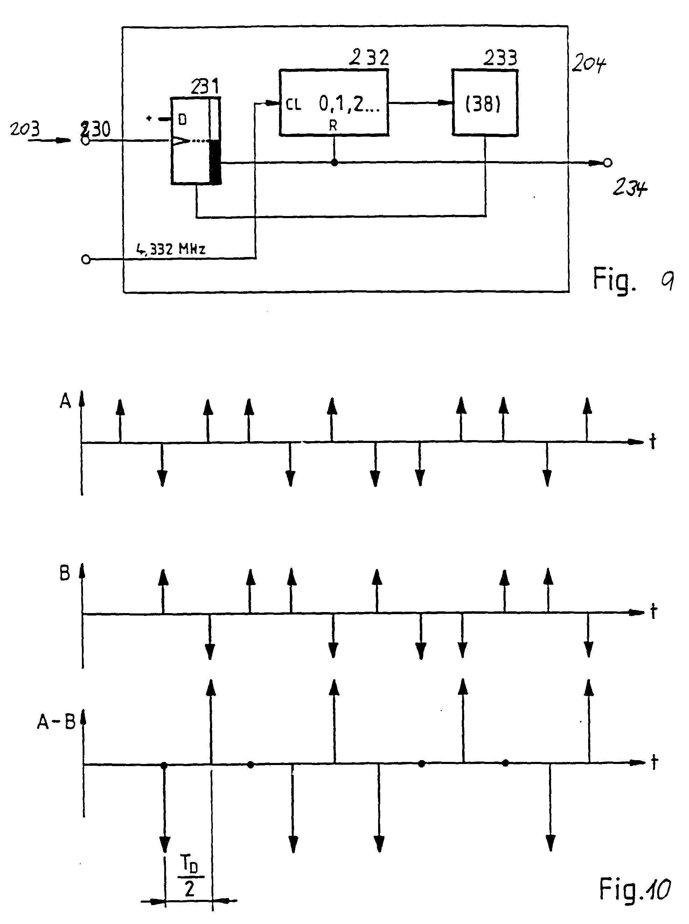

Für die Schaltung 221 ist ein Tastverhältnis der Signale A und B von 50 % erforderlich. Dieses wird im Falle des Signals B mit Hilfe des Zählers 213 in Verbindung mit dem Decoder 214 und dem Flip-Flop 212 sichergestellt. Im Falle des Signals A wird im Impulsformer 204, von dem in Figur 9 ein vorteilhaftes Ausführungsbeispiel dargestellt ist, das Ausgangssignal des Begrenzers dem Takteingang eines Flip-Flops 231 zugeführt, dessen Dateneingang mit positiver Spannung beaufschlagt ist. Durch die Vorderflanke des begrenzten modulierten RDS-Signals wird das Flip-Flop 231 gesetzt. Der invertierende Ausgang des Flip-Flops 231 ist mit dem Rücksetzeingang eines Zählers 232 verbunden, der vom 4,332-MHz-Taktsignal getaktet wird.

Sobald das Flip-Flop 231 gesetzt ist, beginnt der Zähler 232 zu zählen. Mit Hilfe eines Decoders 233 wird der Zähler 232 beim Zählerstand 38 durch Rücksetzen des Flip-Flops 231 ebenfalls zurückgesetzt. Wegen des Frequenzverhältnisses des 4,332-MHz-Takts zur Trägerfrequenz von 57 kHz des RDS-Signals von 76:1 ist beim Zählerstand 38 die halbe Periodendauer abgelaufen. Das Tastverhältnis des Signals am Ausgang 234 beträgt deshalb 50 %.

Figur 10 stellt Signalvektoren der Signale A und B dar, wobei Zeitpunkte ausgewählt wurden, zu denen die Phasen der Signale ihren Extremwert aufweisen. Der Zeitabschnitt $T_D/2$ entspricht einer halben Bittaktperiode. Bei einer Differenzbildung der Signale A und B kommt es zu einer Verdoppelung der Amplitude des RDS-Nutzsignals bzw. zu einer Auslöschung. Damit bleiben Vektoren übrig, welche die Phasendifferenz anzeigen. Weil die Phasendifferenzvektoren vergleichsweise doppelt so groß sind wie die Signale bei bekannten Demodulatoren, ist die Empfindlichkeit des hier beschriebenen neuen RDS-Demodulators erheblich größer. Durch die Empfindlichkeit ergeben sich beim RDS-Empfang eine Reihe von Vorteilen. So ist beispielsweise Frequenz-Diversity auch bei nur schwach empfangbaren Sendern möglich. Der PS (Programm-Service-Name) kann bei schwach empfangbaren Sendern wegen der kleineren Fehlerrate schneller ermittelt werden bzw. das Lesen des PS wird bei sehr schwachen Sendern erst ermöglicht.

Figur 11 zeigt Einzelheiten der Schaltung 221 (Figur 8). Die Signale A und B werden Eingängen 241,242 zugeführt und mit Hilfe einer Exklusiv-Oder-Schaltung 243 miteinander verknüpft. Das entstandene Signal E wird zum Rücksetzen eines Zählers 245 und nach einer Invertierung bei 244 zum Rücksetzen eines Zählers 246 verwendet. Beide Zähler 245,246 werden von einem bei 247 zugeführten 4,332-MHz-Taktsignal getaktet.

Die Ausgänge der Zähler 245,246 sind mit je einem Komparator 249,250 verbunden, dem über einen weiteren Eingang 251 ein Sollwert S1 zuführbar ist. Bei Gleichheit der Signale an den Komparatoreingängen geben die Komparatoren jeweils ein Signal V1 bzw. V2 ab, das je einem Takteingang eines weiteren Zählers 252 und 253 zugeführt wird.

Die Ausgänge der Zähler 252,253 sind mit Eingängen weiterer Komparatoren 254,255 verbunden, die ferner mit einem zweiten Sollwert S2 beaufschlagt sind, der über einen Eingang 256 zugeführt wird. Im Falle von Gleichheit der jeweils einem Komparator zugeführten Signale steht an den Ausgängen der Komparatoren 254,255 ein Signal V3 bzw. V4 an, mit dem ein Flip-Flop 257 gesetzt oder zurückgesetzt wird. Ein Ausgang 258 des Flip-Flops 257 bildet den Ausgang der Schaltungsanordnung nach Figur 11 und ist außerdem mit dem Rücksetzeingang des Zählers 252 verbunden. Der andere Ausgang des Flip-Flops 257 ist an den Rücksetzeingang des Zählers 253 angeschlossen.

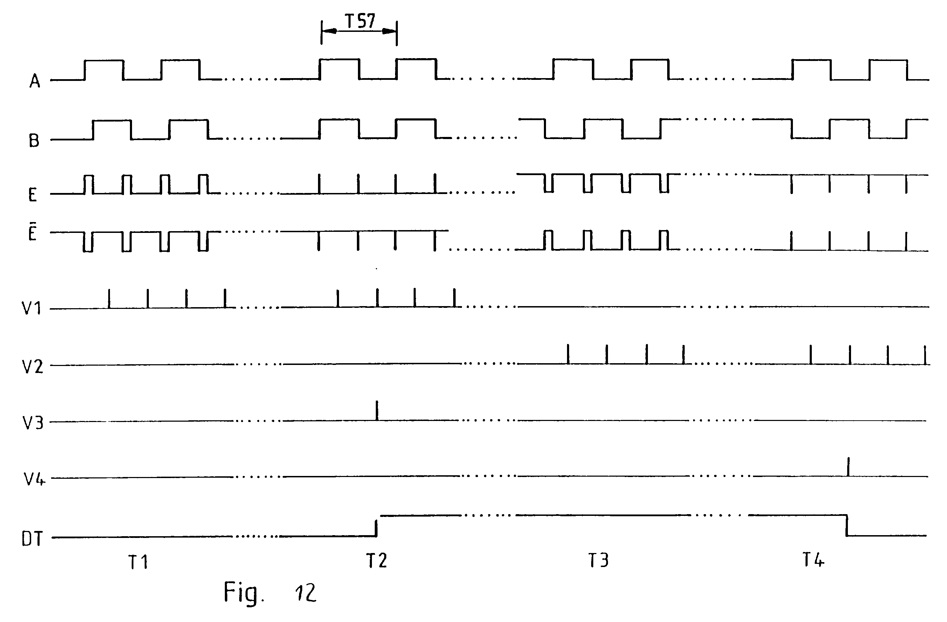

Im folgenden wird die Funktion der Schaltungsanordnung nach Figur 11 unter Bezugnahme auf die in Figur 12 dargestellten Signale erläutert. Die gleichlautend mit Figur 11 bezeichneten Signale sind in Figur 12 in vier verschiedenen Zeitabschnitten T1 bis T4 dargestellt, was durch die punktierten Linien angedeutet ist. Die Impulsbreiten der Signale E und $\overline{E}$ sind von der Phasendifferenz der Signale A und B abhängig. Und zwar ist die Impulsbreite des Signals E kleiner als diejenige des Signals $\bar{E}$, wenn die Phasendifferenz kleiner als 90° ist. Dieses ist während der beiden Zeitabschnitte T1 und T2 der Fall. In den Zeitabschnitten T3 und T4 ist die Phasendifferenz jedoch größer, weshalb die Impulsbreite bzw. das Tastverhältnis des Signals E größer als beim Signal $\bar{E}$ ist.

Bei kleinen Phasenunterschieden erreicht der Zähler 245 den Sollwert S1 öfter innerhalb einer Periode der Signale A und B als der Zähler 246. Dadurch wird der Zähler 252 so häufig inkrementiert, daß er während einer halben Bittaktperiode des RDS-Signals den Sollwert S2 erreicht, während der Zähler 253 rückgesetzt bleibt. Daraufhin wird über das Signal V3 das Flip-Flop 257 gesetzt. Bei großen Phasenunterschieden, das heißt, wenn kein Pegelwechsel des RDS-Datensignals vorliegt, hat sich das Tastverhältnis von E und $\bar{E}$ gegenüber dem beschriebenen Fall umgekehrt, so daß der Zähler 246 öfter den Sollwert S1 erreicht als der Zähler 245. Dementsprechend erreicht der Zähler 253 den Wert S2 und der Zähler 252 bleibt rückgesetzt. Damit wird über den Komparator 250 das Flip-Flop 257 zurückgesetzt. Nach jedem Kippen des Flip-Flops 257 wird jeweils einer der Zähler 252,253 zur Zählung freigegeben und der andere gesperrt. Durch die wechselseitige Verriegelung der Zähler wird die Störsicherheit der Schaltung erhöht. Das somit entstandene Datenimpulssignal DT wird dem Flip-Flop 225 (Figur 8) zugeführt.

Die Sollwerte S1 und S2 sind derart ausgelegt, daß ein Setzen bzw. Rücksetzen des Flip-Flops 257 auch bei gestörten Empfangssignalen unkritisch ist, solange die eine oder andere Phasenlage des RDS-Signals überwiegt.

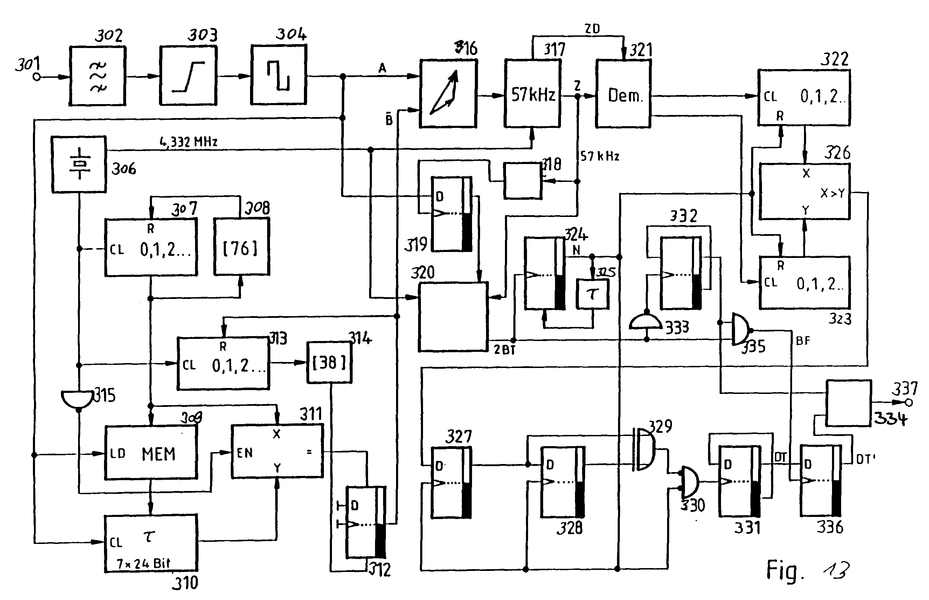

Dem in Figur 13 dargestellten Demodulator gemäß einem dritten Ausführungsbeispiel wird bei 301 das empfangene Multiplexsignal zugeführt. In einem Bandpaß 302 wird aus dem Multiplexsignal das RDS-Signal gewonnen, dessen Amplitude in einem anschließenden Begrenzer 303 begrenzt wird. In einem Impulsformer 304 wird aus dem begrenzten RDS-Signal ein Rechtecksignal mit einem Tastverhältnis von 50 % erzeugt, das die Phasenmodulation des RDS-Signals enthält und im folgenden Signal A genannt wird.

Zur Erzeugung eines 57-kHz-Taktsignals dient ein Quarzoszillator 306 mit einer Frequenz von 4,332 MHz, welche mit einem ersten Zähler 307 und einem ersten Decoder 308 durch 76 geteilt wird. Sobald der erste Zähler 307, dem das Ausgangssignal des Quarzoszillators 306 als Takt zugeführt wird, bis 76 gezählt hat, wird dieses vom Decoder 308 erkannt und der Zähler zurückgesetzt.

Mit Hilfe der Schaltungen 309 bis 315 wird das Signal A um eine halbe Periode des RDS-Bittaktes verzögert. Dabei wird die Phasenlage des Signals A auch im verzögerten Signal genau eingehalten. Das verzögerte Signal wird im folgenden Signal B genannt. Mit jeder positiven Flanke des Signals A wird der Zählerstand des Zählers 307, der 7 Bit umfaßt, in einen Speicher 309 übernommen. Damit steht der Phasenunterschied zwischen dem mit Hilfe des Zählers 307 und des Decoders 308 erzeugten 57-kHz-Taktsignal und dem Signal A für die jeweilige Flanke des Signals A fest. Dieser Phasenunterschied wird mit Hilfe einer Verzögerungsschaltung 310 um eine halbe Bittaktperiode verzögert, was in vorteilhafter Weise mit sieben Schieberegistern mit jeweils einer Länge von 24 Bit erfolgt.

Die in den Speicher 309 geladenen Zählerstände werden mit Flanken des Signals A bis zum Ausgang der Schieberegister geschoben. Mit dem Komparator 311 wird das 7 Bit breite Ausgangssignal der Schieberegister mit dem Zählerstand des Zählers 307 verglichen. Das Ausgangssignal des Komparators wird freigegeben, wenn der Zähler 307 nicht inkrementiert wird, wozu das 4,332-MHz-Taktsignal über einen Invertierer 315 einem Enable-Eingang EN des Komparators zugeführt wird. Sind das Ausgangssignal der Verzögerungsschaltung 310 und der Zählerstand gleich, wird ein Flip-Flop 312 gesetzt und der Zähler 313 freigegeben, womit ein Impuls des Signals B beginnt. Hat der Zähler 313 den Zählerstand 38 erreicht, setzt ein Decoder 314 das Flip-Flop 312 wieder zurück, wodurch der jeweilige "1-Pegel" des Signals B beendet und der Zähler 313 rückgesetzt wird.

Dem invertierenden Ausgang des Flip-Flops 312 wird das Signal $\bar{B}$ entnommen und zusammen mit dem Signal A einer Schaltung 316 zur vektoriellen Addition und Begrenzung zugeführt. Durch die vektorielle Addition der Signale A und $\bar{B}$ werden beim Radio-Datensystem mit Verkehrsfunksignalen Signalkomponenten gebildet, die sich, in halben Bittaktperioden betrachtet, in der Phase um 180° unterscheiden. Beim Radio-Datensystem ohne Verkehrsfunksignale weichen die Signalkomponenten entsprechend in positiver und negativer Richtung von der 57-kHz-Trägerfrequenz ab.

Aus dem Signal A + $\bar{B}$, das im folgenden mit Z bezeichnet wird, wird bei 317 mit Hilfe des 4,332-MHz-Taktsignals der 57-kHz-Hilfsträger regeneriert und um 90° gegenüber den RDS-Signal-komponenten bei RDS-Empfang mit Verkehrsfunk gedreht. Mit dem bei 318 phasenkorrigierten 57-kHz-Träger und dem Signal A kann mit Hilfe eines Flip-Flops 319 ein demoduliertes Signal gewonnen werden, aus welchem mit Hilfe des 4,332-MHz-Taktsignals in der Schaltung 320 die doppelte Bittaktfrequenz abgeleitet wird. Die Phasenkorrektur des 57-kHz-Trägers bei 318 wird wegen einer bei der vektoriellen Addition auftretenden Laufzeit notwendig.

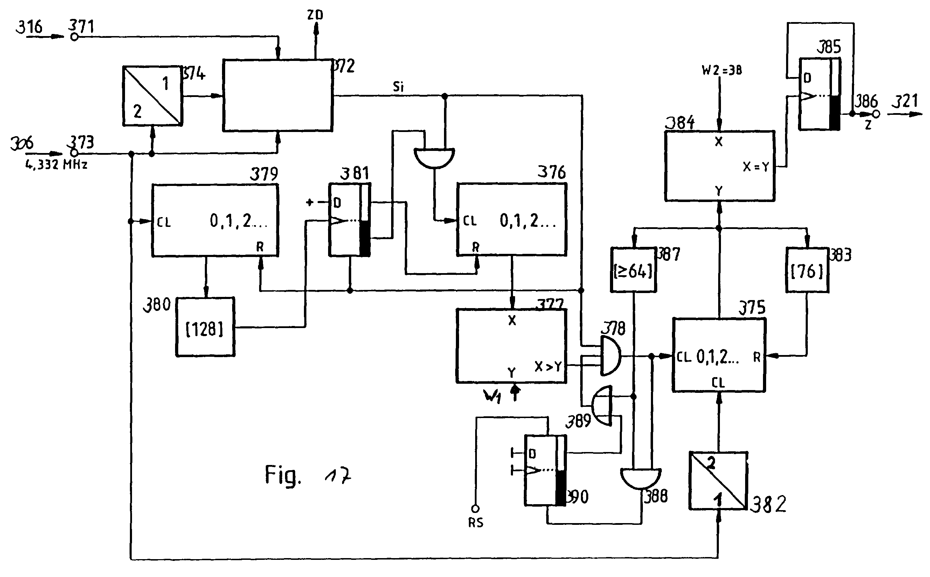

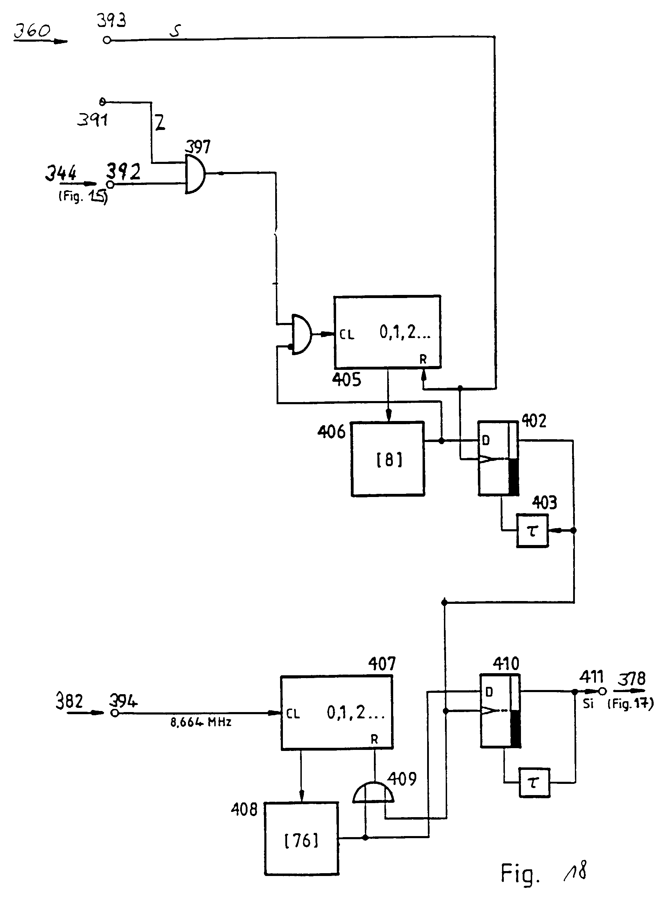

Zur RDS-Demodulation wird ein vom Signal Z abgeleitetes Signal ZD ausgewertet, bei dem die Signalanteile mit kleinen Amplituden unwirksam bleiben und beim Radio-Datensystem mit Verkehrsfunksignalen die Signalkomponenten optimal unterschieden werden können. Das Signal ZD und die Ableitung des 57-kHz-Trägers werden später im Zusammenhang mit den Figuren 17 und 18 genauer beschrieben. Das Signal ZD und der 57-kHz-Träger werden einem Frequenz/Phasenmodulator 321 zugeführt, der zwei Ausgangssignale liefert, mit denen je ein Zähler 322,323 getaktet wird.

Aus einem Signal 2BT mit doppelter Bittaktfrequenz werden mit Hilfe eines Flip-Flops 324 und einer Verzögerungsschaltung 25 Nadelimpulse N abgeleitet, mit denen die Zähler 322,323 zurückgesetzt werden. Bei jedem Impuls N wird das mit einem Komparator 326 ermittelte Vergleichsergebnis der Zählerstände in ein weiteres Flip-Flop 327 übernommen. Dabei gelangt das zuvor erhaltene Ergebnis in ein daran anschließendes Flip-Flop 328. Wenn die Inhalte der Flip-Flops 327 und 328 gleich sind und der Impuls N "0" geworden ist, wird der Inhalt des Flip-Flops 331 verändert. Dazu sind Ausgänge der Flip-Flops 327,328 über eine Exklusiv-Oder-Schaltung 329 und eine Und-Schaltung 330 mit invertierenden Eingängen mit dem Takteingang des Flip-Flops 331 verbunden. Am Ausgang des Flip-Flops 331 liegt somit bereits das RDS-Datenimpulssignal DT an.

Mit der negativen Flanke des doppelten Bittaktsignals 2BT wird ein weiteres Flip-Flop 332 getaktet, wozu der Ausgang der Schaltung 320 über einen Invertierer 333 mit dem Takteingang des Flip-Flops 332 verbunden ist. Das Flip-Flop 332 ist als Zweiteiler geschaltet und liefert den Bittakt BT für einen RDS-Differenzdecoder 334, der an sich bekannt ist und im vorliegenden Zusammenhang nicht näher beschrieben zu werden braucht.

Aus den Taktsignalen 2BT und BT wird mit Hilfe einer Nicht- Und-Schaltung 335 ein Taktsignal BF gebildet, welches ein Flip-Flop 336 taktet, das das RDS-Datentakt-Signal vom Ausgang des Flip-Flops 331 zum RDS-Differenzdecoder 334 leitet, von dessen Ausgang 337 das demodulierte RDS-Signal abgenommen werden kann.

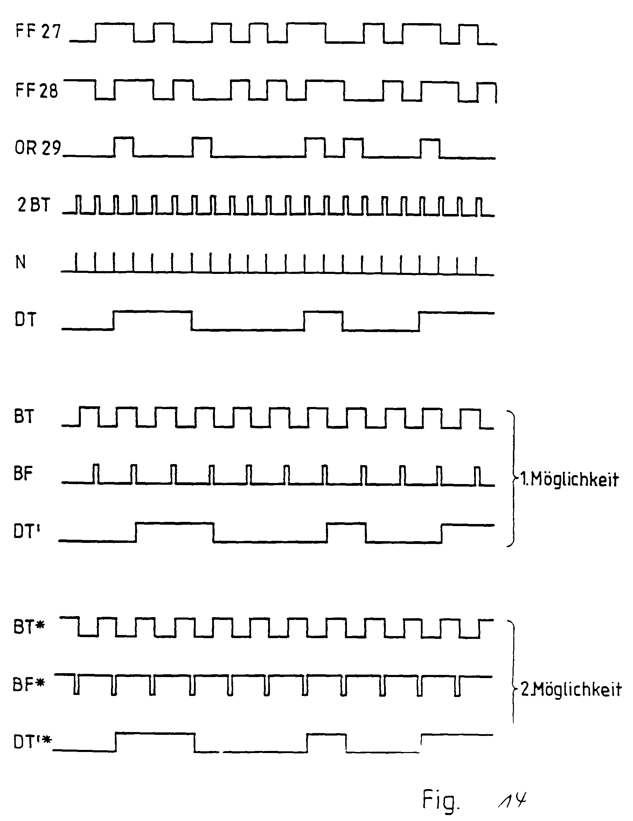

Figur 14 zeigt Zeitdiagramme verschiedener bei dem Demodulator nach Figur 13 auftetender Signale. Die beiden mit FF27 und FF28 bezeichneten Zeilen stellen die Ausgangssignale der Flip-Flops 327 und 328 dar, die gegeneinander um eine Periodendauer des Taktes 2BT verschoben sind. Zu den Zeitpunkten der Nadelimpulse N wird das Flip-Flop 331 getriggert, wenn die Ausgangssignale der Flip-Flops 327 und 328 gleichen Pegel aufweisen. Dadurch entsteht das Signal DT.

Durch die Frequenzteilung mit Hilfe des Flip-Flops 332 können zwei verschiedene Phasenlagen des Signals BT entstehen. Beide Möglichkeiten sind in Figur 14 dargestellt, wobei zur Kennzeichnung der zweiten Möglichkeit die Zeichnungen der Signale mit einem * versehen sind. Die dadurch entstehende Phasenverschiebung des RDS-Signals hat jedoch keine nachteiligen Auswirkungen.

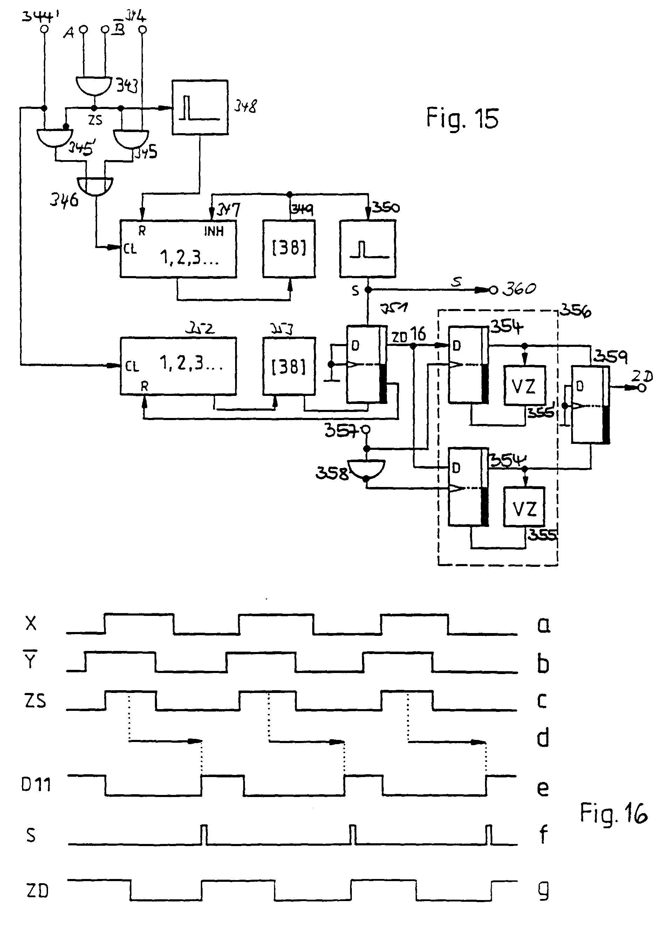

Die im Blockschaltbild angegebene vektorielle Addition 316 der Signale A und B kann in vorteilhafter Weise mit der in Figur 15 dargestellten digitalen Schaltung erfolgen. In dieser Schaltung auftretende Signale sind in Figur 16 gezeigt. Über Eingänge werden die Signale A und B (Zeilen a und b) einer Und-Schaltung 343 zugeführt, an deren Ausgang ein Signal ZS (Zeile c) ansteht. Solange das Signal ZS=1 ist, gelangen Zählimpulse mit einer Frequenz von 2,166 MHz, die einem Eingang 343 zugeführt werden, über eine Und-Schaltung 345 und eine Oder-Schaltung 346 zum Takteingang eines Zählers 347. Während der übrigen Zeit, während der ZS=0 ist, wird der Zähler 347 mit Quarztaktisignalen betrieben, deren Frequenz 4,332 MHz beträgt und die über einen weiteren Eingang 344', eine weitere Und-Schaltung 345' und über die Oder-Schaltung 346 zum Zähler 347 gelangen.

Mit einem Impulsformer 348 wird von jeder positiven Flanke des Signals ZS ein Nadelimpuls abgeleitet, der den Zähler 347 rücksetzt. An den Ausgang des Zählers 347 ist ein Decoder 349 angeschlossen, der beim Zählerstand [38] den Zähler 347 sperrt. Außerdem wird das Ausgangssignal des Decoders 349 (Zeile e) einem weiteren Impulsformer 350 zugeführt, der mit jeder positiven Flanke des Ausgangssignsl des Decoders 349 einen kurzen Synchronimpuls S an einen Ausgang 360 und an den Setzeingang eines Flip-Flops 351 abgibt (Zeile f). Dadurch, daß der Zähler 347 während ZS=1 mit halber Quarztaktfrequenz getaktet wird, beginnt der Zähler 347 mit dem Zählen von Quarztaktimpulsen scheinbar in der Mitte der Impulse des Signals ZS. Diese scheinbare Zählweise ist in Zeile d der Figur 16 durch Pfeile dargestellt.

Der bei 344' zugeführte Quarztakt mit der Frequenz von 4,332 MHz gelangt ferner zu einem Takteingang eines weiteren Zählers 352, dessen Ausgang mit dem Eingang eines weiteren Decoders 353 verbunden ist, der einen vorgebbaren Wert von [38] aufweist. Der Ausgang des Decoders 353 ist an einen Rücksetzeingang des Flip-Flops 351 angeschlossen, dessen invertierender Ausgang mit dem Rücksetzeingang des Zählers 352 verbunden ist. Der nichtinvertierende Ausgang des Flip-Flops 351 führt das Signal ZD, das in Zeile g der Figur 16 dargestellt ist.

Sobald das Flip-Flop 351 durch den Synchronimpuls S gesetzt ist, kann der Zähler 352 mit dem Zählen beginnen und setzt über den Decoder 353 das Flip-Flop 351 bei Erreichen des Wertes [38] zurück. Das Signal ZD ist gegenüber dem vektoriellen Summensignal ZS um 90° phasenverschoben.

Das Signal ZD wird ferner den Dateneingängen zweier Flip-Flops 354,354' zugeführt. Diese bilden zusammen mit Verzögerungsschaltungen 355,355' einen Frequenz/Phasen-Demodulator 356. Über einen Eingang wird ein regenerierter 57-kHz-Hilfsträger zugeführt, der direkt an den Takteingang des Flip-Flops 354 und nach Invertierung bei 358 an den Takteingang des Flip-Flops 354' gelangt. Jedes Setzen eines der Flip-Flops 354,354' bewirkt über die Verzögerungsschaltungen 355,355' ein anschließendes Rücksetzen der Flip-Flops. Mit den Ausgangsimpulsen des Flip-Flops 354 wird ein weiteres Flip-Flop 359 gesetzt. Mit den Ausgangsimpulsen des Flip-Flops 354' wird das Flip-Flop 359 rückgesetzt. Das Flip-Flop 359 liefert an seinem Ausgang das demodulierte Signal ZD.

Figur 17 zeigt ein Ausführungsbeispiel für einen Trägerregenerator, der einen 57-kHz-Träger aus dem Signal Z gewinnt. Dazu wird das Signal Z über einen Eingang 371 einer Schaltung 372 zur Synchronimpulserzeugung zugeführt. Die Schaltung 372 erhält über einen weiteren Eingang 373 das 4,332-MHz-Taktsignal direkt und ein Signal halber Frequenz über einen Frequenzteiler 374. Einzelheiten der Schaltung 372 werden später im Zusammenhang mit Figur 18 näher erläutert.

von der Schaltung 372 erzeugte Synchronimpulse SI treten dann auf, wenn das Signal Z relativ genau einer 57-kHz-Taktperiode entspricht und mit der Phase eines in der Schaltung 372 vorhandenen synchronisierbaren Teilers übereinstimmt. Die Synchronimpulse SI werden von einer Und-Schaltung 378 erst dann zur Synchronisation eines Zähers 375 freigegeben, wenn ein weiterer Zähler 376 einen an einem Komparator 377 anliegenden Sollwert W1 überschritten hat. Außerdem wird mit Hilfe eines Zählers 379, eines Decoders 380 und eines Flip-Flops 381 überwacht, ob die Synchronimpulsfolge SI, mit welcher der Zähler 376 inkrementiert wird, kontinuierlich ist. Bei Impulslücken erreicht der Zähler 379 den durch den Decoder 380 gegebenen Wert von beispielsweise [128]. Dann wird das Flip-Flop 381 gesetzt und der Zähler 376 zurückgesetzt. Der Zähler 376 kann dann mit dem nächsten Impuls des Signals SI neu gestartet werden. Der Zähler 375 wird mit doppelter Frequenz getaktet, die aus dem 4,332-MHz-Taktsignal mit Hilfe einer Frequenzverdoppelungsschaltung 382 erzeugt wird, und wird mit Hilfe eines Decoders 383 beim Zählerstand [76] zurückgesetzt.

Weiterhin kann der Zähler 375 nur synchronisiert werden, wenn er entweder den Zählerstand "≥64" erreicht hat oder das Flip-Flop 390 gesetzt ist. Die entsprechende Verknüpfung erfolgt mit der Oder-Schaltung 389. Diese Maßnahme dient dazu, Synchronimpulse im Zählbereich 0 bis 63 des Zählers 375 unwirksam zu machen, denn diese sind als Störgröße anzusehen. Um jedoch ein schnelles Einschwingen des Demodulators zu gewährleisten, ist es erforderlich, die Bedingung solange aufzuheben, bis ein Synchronimpuls in den Zählbereich "≥64" fällt. Dazu wird zu Beginn des Einschwingens mit einem extern generierten Impuls "RS" das Flip-Flop 390 gesetzt.

Die genannten vier Bedingungen zur Synchronisation des Zähler 375 haben den Zweck, ein Jittern des 57-kHz-Trägers zu vermindern. Weil der Zähler 375 mit der doppelten Frequenz des Quarztaktsignals betrieben und bei dem Zählerstand [76] zurückgesetzt wird, entspricht eine Zählperiode einer Frequenz von 114 kHz. Mit einem Komparator 384, dem ein Sollwert W2 = 38 zugeführt wird, wird der Zählerstand [38] selektiert. Mit dem Ausgangsimpuls des Komparators 384 wird ein Flip-Flop 385 getriggert, das an seinem Ausgang 386 den gewünschten 57-kHz-Träger liefert, der bei einem RDS-System mit Verkehrsfunksignalen gegenüber dem Signal ZD um 90° phasengedreht ist.

Figur 18 zeigt ein Blockschaltbild der Schaltung 372 (Figur 17) zur Erzeugung des Synchronimpulses SI. Der Schaltung werden über Eingänge 391,392,393,394 das Signal Z, das 2,166-MHz-Taktsignal, der Synchronimpuls S und der Takt mit der doppelten Frequenz des 4,332-MHz-Taktsignals zugeführt.

Die positive Flanke des Synchronimpulses S taktet ein Flip-Flop 402, das nach einer kurzen, durch ein Verzögerungsglied 403 bedingten Zeit, wieder zurückgesetzt wird. Dieser Nadelimpuls wird jedoch nur dann erzeugt, wenn ein Zähler 405 den in einem Decoder 406 abgelegten Wert erreicht hat. Hiermit wird bewirkt, daß nur Z-Impulse ab einer vorgegebenen Impulsbreite ausgewertet werden.

Mit den Ausgangsimpulsen des Flip-Flops 402 wird ein synchronisierbarer Frequenzteiler gestartet, der aus einem Zähler 407, einem Decoder 408 und einer Oder-Schaltung 409 besteht. Die Periodendauer des vom Zähler 407 erzeugten Signals entspricht einer halben 57-kHz-Taktperiode.

Basis zur Erzeugung der Synchronimpulse SI ist der mit der doppelten Quarztaktfrequenz betriebene Zähler 407. Wenn die positive Flanke des Ausgangsimpulses des Flip-Flops 402 während des durch den Decoder 408 eingeleiteten Rücksetzvorgangs auftritt, wird mit einem Flip-Flop 410 ein Nadelimpuls erzeugt, der dem Ausgang 411 als Signal SI entnehmbar ist. In diesem Fall kann davon ausgegangen werden, daß beim Empfang von RDS-Signalen mit Verkehrsfunksignalen die Phase des Signals Z zur Synchronisation auswertbar ist und daß bei RDS-Signalen sich das momentane Signal Z im Bereich von 57 kHz befindet.

Die Synchronimpulse S treten in der Regel in Zeitabständen von 57-kHz-Taktperioden auf. Die Zählperiode des Zählers 407 entspricht 114 kHz, es ist jedoch gleichgültig, ob der Träger bei seiner positiven oder negativen Taktflanke synchronisiert wird.

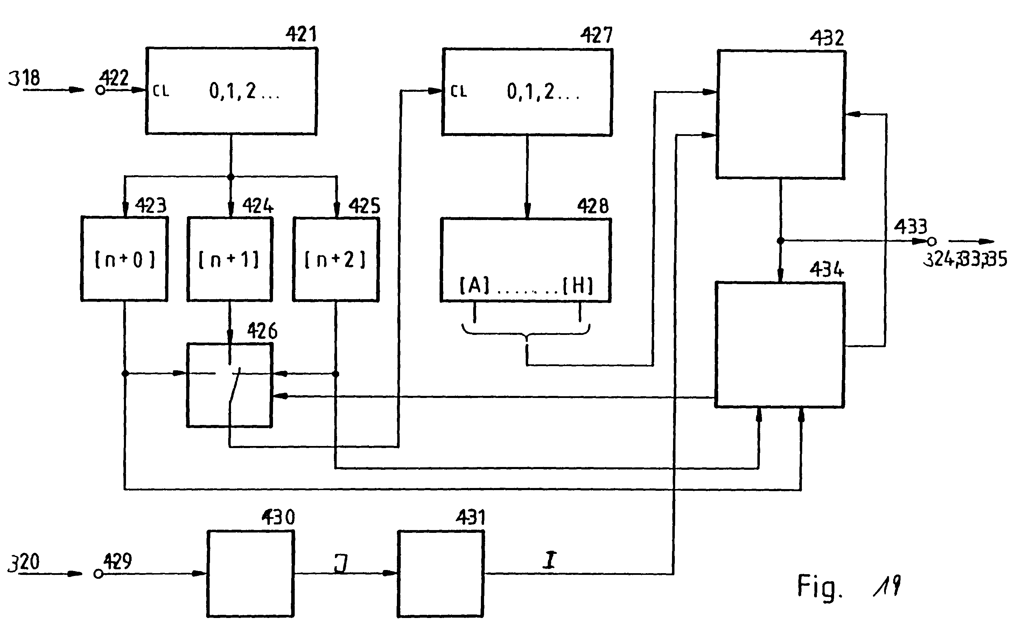

Die Schaltung 320 (Figur 13) zur Gewinnung der doppelten Bit-taktfrequenz wird im folgenden anhand von Figur 19 näher erläutert. Ein Zähler 421 dient als Vorteiler und wird mit dem bei 422 zugeführten 57-kHz-Träger getaktet. Mit Hilfe dreier Decoder 423 bis 425 werden bei drei benachbarten Zählerständen Impulse abgeleitet, von denen jeweils ein Impuls mit Hilfe eines Umschalters 426 ausgewählt wird, um einen weiteren Zähler 427 zu takten. Dessen Ausgang ist mit einem Achtfach-Decoder 428 verbunden, an dessen Ausgängen A bis H jeweils ein Impuls bei einem von acht benachbarten Zählerständen ausgegeben wird.

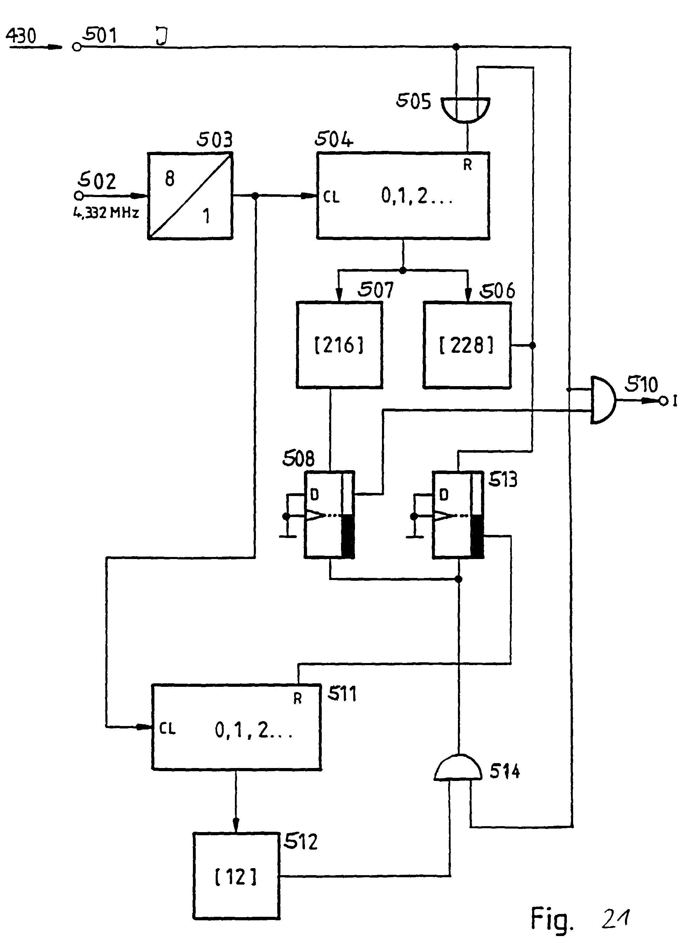

Mit den Zähler 421 und 427 wird an sich schon ein Takt mit der doppelten Bittaktfrequenz abgeleitet. Die beschriebenen Decoder sowie die im folgenden beschriebenen Schaltungen dienen jedoch dazu, die Phase des Bittaktes nach möglichst kurzer Zeit richtig einzustellen. Zu diesem Zweck wird zunächst über einen Eingang 429 ein Signal zugeführt, das durch Demodulation des Signals A mit Hilfe des Flip-Flops 319 und des 57-kHz-Trägers (Figur 13) erzeugt wird. Aus den Taktflanken dieses Signals werden in einem Impulsformer 430 Nadelimpulse abgeleitet, die einer Impulsfreigabeschaltung 431 zugeführt werden, welche später im Zusammenhang mit Figur 21 näher erläutert wird.

Die Ausgangs impulse I der Impulsfreigabeschaltung werden einer Phasenauswahlschaltung 432 zugeführt, welche von den an den Ausgängen A bis H des Decoders 428 anstehenden Impulsen denjenigen mit der richtigen Phasenlage auswählt und als Signal 2BT mit doppelter Bittaktfrequenz zum Ausgang 433 führt. Mit Hilfe einer Schaltung 434 zur Phasenfeinregelung wird eines der Ausgangssignale der Decoder 423,424,425 über den Umschalter 426 ausgewählt.

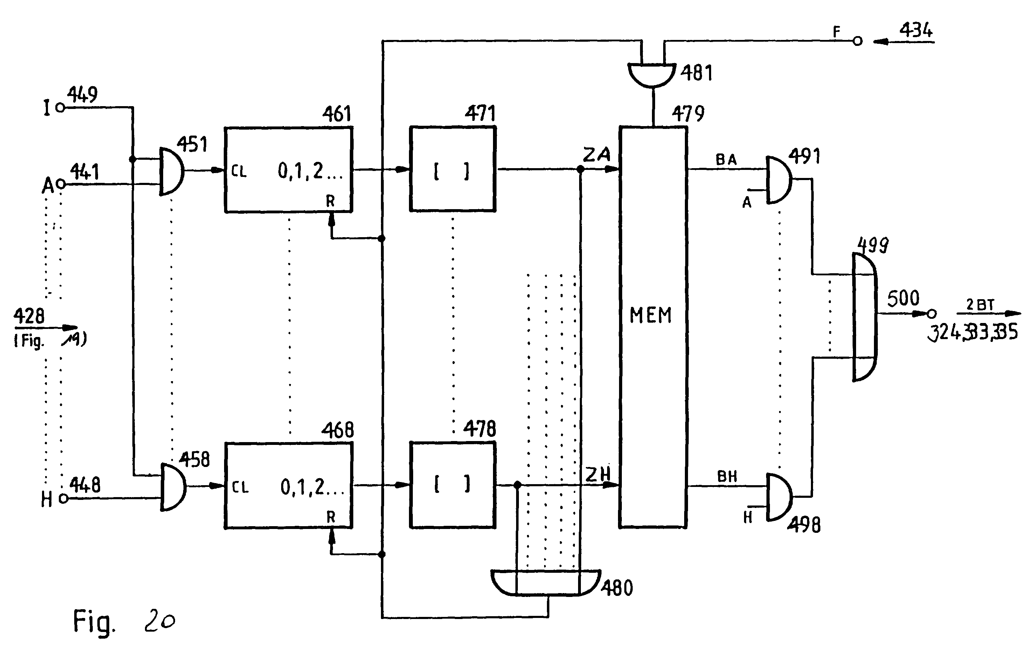

Im folgenden wird anhand von Figur 20 die Phasenauswahlschaltung 432 (Figur 19) näher erläutert. Von jeweils acht gleichen Teilen sind stellvertretend nur zwei Teile dargestellt. Eingängen 441 bis 448 werden die Impulse A bis H vom Decoder 428 (Figur 19) zugeführt. Über einen weiteren Eingang 449 erhält die Phasenauswahlschaltung die Impulse I der Freigabeschaltung 431 (Figur 19). Diese werden mit jedem der Impulse A bis H in den Und-Schaltungen 451 bis 458 verknüpft, deren Ausgänge mit Takteingängen von Zählern 461 bis 468 verbunden sind. Daran schließen sich Decoder 471 bis 478 an, deren Ausgänge mit einem Speicher 479 und einer Oder-Schaltung 480 verbunden sind. Der Ausgang der Oder-Schaltung 480 ist mit Rücksetzeingängen der Zähler 461 bis 468 und mit einem Eingang einer Und-Schaltung 481 verbunden, deren anderer Eingang mit einem Freigabesignal F beaufschlagt ist, das von der Phasenfeinregelschaltung 434 (Figur 19) zugeführt wird.

Ausgänge des Speichers 479 sind über je eine Und-Schaltung 491 bis 498 mit einer Oder-Schaltung 499 verbunden, an deren Ausgang 500 das Taktsignal 2BT abnehmbar ist.

Die Werte der Decoder 471 bid 478 sind untereinander gleich. Einer der Zähler erreicht zuerst den Decoderwert, worauf über die Oder-Schaltung 480 alle Zähler zurückgesetzt werden und der Vorgang wiederholt wird. Bei jedem Rücksetzen der Zähler werden die decodierten Zählerstände in den Speicher 479 übernommen, wobei nur derjenige Zähler, der zuerst den Decoderwert erreicht hat, einen 1-Pegel am Ausgang seines Decoders aufweist. Mit Hilfe der Und-Schaltungen 491 bis 498 und den Ausgängen des Speichers 479 wird dann derjenige Impuls A bis H ausgewählt, der die richtige Phase aufweist.

Figur 21 stellt ein Blockschaltbild der Impulsfreigabeschaltung 431 (Figur 19) dar. Einem ersten Eingang 501 wird das Ausgangssignal des Impulsformer 430 (Figur 19) zugeführt, während ein zweiter Eingang 502 das 4,332-MHz-Taktsignal erhält, welches anschließend bei 503 durch acht geteilt wird. Damit wird ein Zähler 504 getaktet, der von den bei 501 zugeführten Impulsen J über eine Oder-Schaltung 505 zurückgesetzt wird. Der Zähler wird ferner bei Erreichen des Wertes [228] mit Hilfe eines Decoders 506 zurückgesetzt, der an den Ausgang des Zählers 504 angeschlossen ist.

An den Ausgang des Zählers 504 ist ferner ein Decoder 507 angeschlossen, der bei dem Zählerstand [216] einen Impuls abgibt, mit welchem ein Flip-Flop 508 gesetzt wird.

Die Taktfrequenz für den Zähler beträgt durch die Frequenzteilung 541,5 kHz, so daß 228 Perioden einer halben RDS-Bittaktperiode von 421,1 µs entsprechen. Im Zeitbereich von 216 Perioden (Decoder 507) bis 240 Perioden werden Nadelimpulse I für die Phasenauswahlschaltung 432 (Figur 19) freigegeben, wozu der Ausgang des Flip-Flops 508 über eine Und-Schaltung 509 mit dem Ausgang 510 der Impulsfreigabeschaltung verbunden ist.

Die Rückflanken der Impulse bei 240 Perioden werden mit Hilfe eines weiteren Zählers 511, eines weiteren Decoders 512 und eines weiteren Flip-Flops 513 festgelegt. Sobald der Zähler 504 den Wert [228] erreicht hat, wird das Flip-Flop 513 gesetzt und der Zähler 511 gestartet, der bis [12] zählt, worauf der Decoder 512 beide Flip-Flops über die Oder-Schaltung 514 zurücksetzt. Beide Flip-Flops werden aber auch zurückgesetzt, wenn ein Impuls J vorhanden ist. Nur diejenigen vom Impulsformer 430 (Figur 19) zugeführten Nadelimpulse, welche in das durch die Impulsfreigabeschaltung erzeugte Zeitfenster fallen, werden als Impuls I über den Ausgang 510 der Phasenauswahlschaltung 432 (Figur 19) zugeführt, da sie für die Gewinnung des RDS-Bittaktsignals als richtig und auswertbar anzusehen sind.

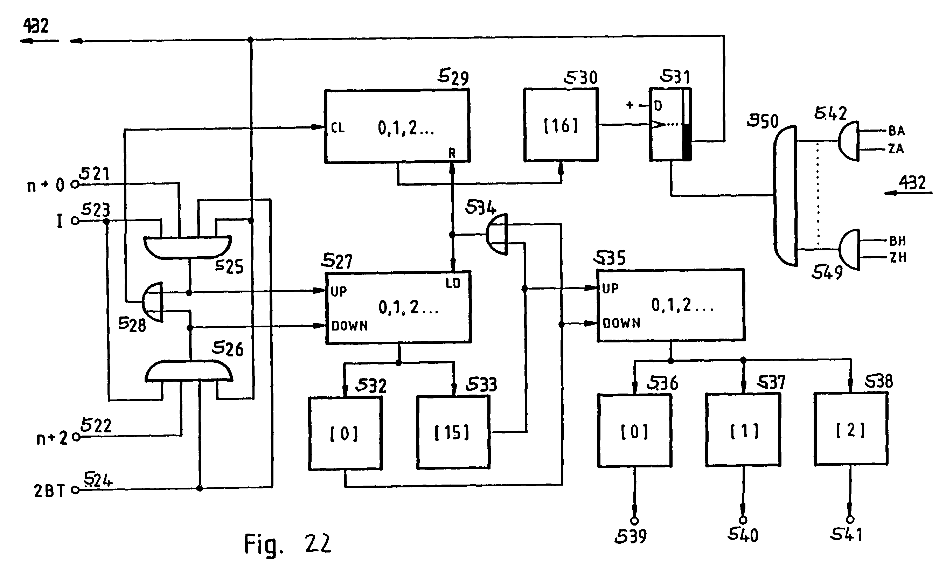

Figur 22 zeigt ein Blockschaltbild der Phasenfeinregelschaltung 434 (Figur 19). In den durch die Decoder 423 bis 425 des Zählers 421 (Figur 19) gegebenen Zeitbereich fällt eine bestimmte Anzahl von I-Impulsen. Mit der Regelschaltung wird diejenige Stellung des Umschalters 426 gefunden, der gleich viele I-Impulse in die beiden äußeren Teilbereich fallen, die mit n+0 und n+2 gekennzeichnet sind. Während dieser Teilbereiche liegt abwechselnd an den Eingängen 521,522 jeweils eine "1" an. Weiteren Eingängen 523,524 werden die I-Impulse und das Taktsignal 2BT mit doppelter Bitfrequenz zugeführt. Die Eingangssignale werden mit Und-Schaltungen 525,526 derart verknüpft, daß die während des Teilbereichs n+0 auftretenden I-Impulse einen Aufwärts/Abwärts-Zähler 527 inkrementieren, während die I-Impulse während des Teilbereichs n+2 den Aufwärts/-Abwärts-Zähler 527 dekrementieren. Dieses erfolgt jedoch nur während der Impulse des Signals 2BT.

Die Ausgänge der Und-Schaltung 525 und 526 sind mit je einem Eingang einer Oder-Schaltung 528 verbunden, deren Ausgang an den Takteingang eines Zählers 529 angeschlossen ist. Ein Decoder 530 erzeugt ein Signal, wenn der Zählerstand des Zählers 529 [16] erreicht hat und setzt damit ein Flip-Flop 531. Dem Aufwärts/Abwärts-Zähler 527 sind zwei Decoder 532,533 zugeordnet mit den Werten [0] und [15]. Sobald einer der Zählerstände erreicht ist, wird über eine Oder-Schaltung 534 der Zähler 529 zurückgesetzt und ein vorgegebener Wert in den Aufwärts/Abwärts-Zähler 527 geladen. Außerdem werden die Ausgangsimpulse der Decoder 532,533 dazu benutzt, einen weiteren Aufwärts/Abwärts-Zähler 535 zu inkrementieren bzw. zu dekrementieren. An den Ausgang des weiteren Aufwärts/Abwärts-Zählers 535 sind drei Decoder 536,537,538 angeschlossen, welche an ihren Ausgängen 539,540,541 jeweils ein Signal abgeben, das eine entsprechende Stellung des Schalters 426 (Figur 19) bewirkt.

Wenn etwa gleich viele I-Impulse in den Teilbereich n+0 und in den Teilbereich n+2 fallen, kann der Zähler 529 bis zum Wert [16] hochzählen, worauf der Decoder 530 das Flip-Flop 531 setzt. Wenn jedoch der Aufwärts/Abwärts-Zähler 527 in kürzerer Zeit den Wert [0] oder [15] erreicht, wird er wieder auf den mittleren Wert [8] geladen und der Zähler 529 wird erneut gestartet, bevor er den Wert [16] erreicht. Außerdem wird der Wert des Aufwärts/Abwärts-Zähler 535 UM, [1] in diejenige Richtung verändert, bei der durch die neue Stellung des Schalters 426 (Figur 19) die gewünschte Verteilung der I-Impulse erreicht werden kann.

Nachdem das Flip-Flop 531 gesetzt wurde, ist die Phasenfeinregelung unterbrochen. Sie kann erst wieder aktiviert wrden, wenn ein anderer der Zähler 461 bis 468 (Figur 20) als der im Speicher 479 zuvor abgelegte zuerst den entsprechenden Decoderwert erreicht. In diesem Fall liegt an einem der Ausgänge der Gatter 542 bis 549 "1-Pegel" an, womit über die Oder-Schaltung 550 das Flip-Flop 531 zurückgesetzt wird.

Es wird mit der beschriebenen Schaltung erreicht, daß sich nach kurzer Zeit die Phasenfeinregelung automatisch abschaltet und damit der RDS-Bittakt praktisch jitterfrei ist. Erst bei großen Phasenfehlern wird die Regelung wieder eingeschaltet, womit eine relativ große Störfestigkeit der RDS-Bittakterzeugung gegeben ist.

**Patentansprüche**

1. Demodulator für Radio-Daten-Signale, deren Übertragung durch Phasenumtastung eines Hilfsträgers erfolgt, der unterdrückt oder mit Verkehrsfunksignalen moduliert sein kann, in dem das hilfsträgerfrequente Signal in ein Rechtecksignal umgewandelt und die Demodulation durch verwertung von Phasenlagen phasenverschobener Werte des Rechtecksignals erfolgt, dadurch gekennzeichnet, daß das empfangene und umgewandelte Signal als erstes Rechtecksignal (A) benutzt wird, dessen Phasenlage bestimmbar und abspeicherbar ist, daß ein bezüglich der abgespeicherten Phasenlage synchronisiertes zeitverschobenes Rechtecksignal (B) gebildet wird und daß die Demodulation durch die Verwertung relativer Phasenlagen der beiden Rechtecksignale (A, B) erfolgt.

2. Demodulator nach Anspruch 1, dadurch gekenzeichnet, daß das empfangene hilfsträgerfrequente Signal in das erste Rechtecksignal (A) mit konstantem Tastverhältnis umgewandelt wird.

3. Demodulator nach Anspruch 1 oder 2, dadurch gekennzeichnet, daß das zweite Rechtecksignal (B) die Hilfsträgerfrequenz aufweist und mit seiner Phasenlage zu bestimmten Zeitpunkten mit der Phasenlage des ersten Rechtecksignals (A) in Übereinstimmung gebracht wird, daß eine sich ergebende Phasendifferenz zwischen den Rechtecksignalen bezüglich ihres zeitlichen Verlaufs und ihrer Größe ausgewertet wird und daß bei Entstehen einer Phasendifferenz innerhalb einer vorgegebenen Zeitspanne ein Ladeimpuls (L) abgeleitet wird, der die Phasenlage des zweiten Rechtecksignals (B) in Übereinstimmung mit der Phasenlage des ersten Rechtecksignals bringt und eine Flanke des demodulierten Radio-Daten-Signals bildet.

4. Demodulator nach Anspruch 3, dadurch gekennzeichnet, daß die Phasendifferenz zwischen den Rechtecksignalen durch Bestimmung der Impulsbreite eines dritten Rechtecksignals (C) erfolgt, welches aus dem ersten und dem zweiten Rechtecksignal mit Hilfe einer Logikschaltung (5), vorzugsweise einer Exklusiv-Oder-Schaltung, abgeleitet wird.

5. Demodulator nach Anspruch 3 oder 4, dadurch gekennzeichnet, daß zur Bildung des ersten Rechtecksignals das empfangene hilfsträgerfrequente Signal einen Zähler (32) startet, der mit einer Frequenz getaktet wird, die ein Vielfaches, vorzugsweise das 76fache, der Frequenz des Hilfsträgers beträgt, und der bei Erreichen des halben Vielfachen zurückgesetzt wird.

6. Demodulator nach einem der Ansprüche 3 bis 5, dadurch gekennzeichnet, daß zur Bildung des zweiten Rechtecksignals (B) ein Zähler (7) vorgesehen ist, der mit einer Frequenz getaktet wird, die ein Vielfaches, vorzugsweise das 76fache, der Frequenz des Hilfsträgers beträgt und der bei Erreichen des Vielfachen zurückgesetzt wird, daß der Zählerstand, der während einer Flanke des ersten Rechtecksignals innerhalb der vom Signal (L) vorgegebenen Dauer auftritt, in einen Speicher (9) geladen wird, daß ein Komparator (11) vorgesehen ist, der den Inhalt des Speichers (9) mit dem Zählerstand vergleicht und daß bei Gleichheit eine Flanke des zweiten Rechtecksignals (B) und eine halbe Periodendauer des Hilfsträgers später die andere Flanke des zweiten Rechtecksignals (B) erzeugt wird.

7. Demodulator nach Anspruch 6, dadurch gekennzeichnet, daß ein weiterer Zähler (13) vorgesehen ist, der ebenfalls mit dem Vielfachen der Hilfsträgerfrequenz getaktet wird, daß der Ausgang des Komparators (11) mit dem Setzeingang eines Flip-Flops (12) verbunden ist, dessen Rücksetzeingang an den Ausgang eines Decoders (14) angeschlossen ist, der ein Signal abgibt, wenn der weitere Zähler einen der halben Periodendauer entsprechenden Zählerstand erreicht hat, und daß ein Ausgang des Flip-Flops (12) mit dem Rücksetzeingang des weiteren Zählers (13) verbunden ist.

8. Demodulator nach einem der vorhergehenden Ansprüche, dadurch gekennzeichnet, daß der Ladeimpuls (L) ferner nur erzeugt wird, wenn die Phasendifferenz zwischen dem ersten und dem zweiten Rechtecksignal innerhalb der Zeit seit dem letzten Ladeimpuls schwellwertabhängig ununterbrochen abgenommen hat.

9. Demodulator nach einem der vorhergehenden Ansprüche, dadurch gekennzeichnet, daß ferner ein Ladeimpuls nur abgeleitet wird, wenn die Summe aller Phasenabweichungen zwischen dem ersten und dem zweiten Rechtecksignal seit dem vorangegangenen Ladeimpuls einen vorgegebenen Schwellwert überschritten hat.

10. Demodulator nach einem der vorhergehenden Ansprüche, dadurch gekennzeichnet, daß ein Taktsignal mit der Frequenz des Hilfsträgers aus dem Quarztaktsignal höherer Frequenz durch Frequenzteilung abgeleitet wird und daß durch weitere Frequenzteilung ein Bittaktsignal für das demodulierte Radio-Daten-Signal erzeugt wird.

11. Demodulator nach Anspruch 10, dadurch gekennzeichnet, daß für die weitere Frequenzteilung mindestens ein Schieberegister (23) vorgesehen ist, das zum Zeitpunkt des Auftretens eines aus dem Ladeimpuls (L) abgeleiteten Datenimpulssignals auf einen vorgegebenen Wert gesetzt wird.

12. Demodulator nach Anspruch 11, dadurch gekennzeichnet, daß ein Ausgang des Schieberegisters (23) mit dem Eingang eines weiteren Schieberegisters (24) verbunden ist, dessen Ausgang das Bittaktisignal führt, daß das vom Ladeimpuls (L) abgeleitete Datenimpulssignal ein Flip-Flop (25) triggert und daß das Ausgangssignal des Flip-Flops (25) und das Bittaktsignal einem Differenz-Decoder (26) zuführbar sind.

13. Demodulator nach Anspruch 1 oder 2, dadurch gekennzeichnet,

- daß das empfangene hilfsträgerfrequente Signal um eine halbe Periode des Bittaktes des Radio-Daten-Signals verzögert wird,
- daß die Phasendifferenz zwischen dem empfangenen und dem verzögerten hilfsträgerfrequenten Signal gemessen wird und
- daß ein Datenimpulssignal abgeleitet wird, das in Abhängigkeit vom Vorzeichen der gemessenen Phasendifferenz einen ersten oder einen zweiten Pegel einnimmt.

14. Demodulator nach Anspruch 13, dadurch gekennzeichnet, daß zur Erzeugung des verzögerten hilfsträgerfrequenten Signals ein Oszillator, der ein Vielfaches der Frequenz des Hilfsträgers erzeugt, und ein Zähler vorgesehen sind, der bei einem Zählerstand zurückgesetzt wird, der dem Vielfachen entspricht, daß der Zählerstand, der bei jeweils einer Flanke des Rechtecksignals vorhanden ist, um eine halbe Bittaktperiode verzögert wird und daß eine Flanke des verzögerten hilfsträgerfrequenten Signals (B) abgeleitet wird, wenn der Zählerstand dem verzögerten Zählerstand entspricht.

15. Demodulator nach Anspruch 14, dadurch gekennzeichnet, daß die Verzögerung mittels Schieberegister erfolgt.

16. Demodulator nach Anspruch 14 oder 15, dadurch gekennzeichnet, daß ein weiterer Zähler vorgesehen ist, der mit dem Vielfachen der Frequenz des Hilfsträgers getaktet wird und der mit einer Flanke des verzögerten hilfsträgerfrequenten Signals (B) gestartet und bei Erreichen des halben Vielfachens gestoppt wird, womit eine weitere Flanke des verzögerten hilfsträgerfrequenten Signals (B) abgeleitet wird.

17. Demodulator nach einem der vorhergehenden Ansprüche, dadurch gekennzeichnet, daß der Pegel des Datenimpulssignals nur dann geändert wird, wenn sich die Phase des hilfsträgerfrequenten Signals (A) in vorgebbarem Maß gegenüber der Phase des verzögerten hilfsträgerfrequenten Signals (B) geändert hat.

18. Demodulator nach Anspruch 17, dadurch gekennzeichnet, daß Zähler (245,252; 246,253) zur Auszählung von Impulsen (E,Ē) mit Taktimpulsen des Oszillators (206) vorgesehen sind und daß bei Erreichen jeweils eines vorgegebenen Zählerstandes das Datenimpulssignal auf den entsprechenden Pegel gesetzt wird.

19. Demodulator nach Anspruch 18, dadurch gekennzeichnet, daß die während der Phasenunterschiede zwischen dem hilfsträgerfrequenten Signal (A) und dem verzögerten hilfsträgerfrequenten Signal (B) gezählten Taktsignale für beide Vorzeichen der Phasenabweichung getrennt mit einem ersten Sollwert verglichen werden, daß jeweils bei Erreichen des ersten Sollwertes ein weiterer Zähler (252,253) je Vorzeichen der Phasenabweichung getaktet wird und daß die Zählerstände der weiteren Zähler (252,253) mit einem weiteren Sollwert verglichen werden und daß einer der Pegel des Datenimpulssignals gesetzt wird, sobald einer der weiteren Zähler (252,253) den weiteren Sollwert erreicht.

**20.** Demodulator nach einem der Ansprüche 17 bis 19, dadurch gekennzeichnet, daß die Zähler (252,253) über ein Flip-Flop (257) wechselseitig freigegeben und rückgesetzt werden.

**21.** Demodulator nach Anspruch 1 oder 2, dadurch gekennzeichnet,

- daß das empfangene hilfsträgerfrequente Signal um eine halbe Periode des Bittaktes des Radio-Daten-Signals verzögert wird,
- daß das empfangene und das verzögerte hilfsträgerfrequente Signal vektoriell addiert werden,
- daß aus dem Ergebnis der vektoriellen Addition ein Rechtecksignal (ZD) abgeleitet wird, dessen Phase von dem empfangenen und dem verzögerten hilfsträgerfrequenten Signal abhängt,
- daß aus dem vektoreill addierten Signal der Hilfsträger wiedergewonnen wird, und
- daß von dem Rechtecksignal ein Datenimpulssignal abgeleitet wird, das in Abhängigkeit vom Vorzeichen der gemessenen Phasendifferenz zwischen dem Rechtecksignal und dem wiedergewonnenen Hilfsträger einen ersten und einen zweiten Pegel einnimmt.

**22.** Demodulator nach Anspruch 21, dadurch gekennzeichnet, daß daß Rechtecksignal nur zur Demodulation ausgewertet wird, wenn die Amplitude des vektoriell addierten Signals ausreichend groß ist.

**23.** Demodulator nach Anspruch 21 oder 22, dadurch gekennzeichnet, daß ein Signal mit der doppelten Bittaktfrequenz aus dem wiedergewonnenen Hilfsträger und dem unverzögerten Signal (A) oder dem verzögerten Signal (B) abgeleitet wird und zur Demodulation verwendet wird.

**24.** Demodulator nach einem der Ansprüche 21 bis 23, dadurch gekennzeichnet, daß zur Erzeugung des verzögerten hilfsträgerfrequenten Signals ein Oszillator, der ein Vielfaches der Frequenz des Hilfsträgers erzeugt, und ein Zähler vorgesehen sind, der bei einem Zählerstand zurückgesetzt wird, der dem Vielfachen entspricht, daß der Zählerstand, der bei jeweils einer Flanke des Rechtecksignals vorhanden ist, um eine halbe Bittaktperiode verzögert wird und daß eine Flanke des verzögerten hilfsträgerfrequenten Signals (B) abgeleitet wird, wenn der Zählerstand dem verzögerten Zählerstand entspricht.

**25.** Demodulator nach Anspruch 24, dadurch gekennzeichnet, daß die Verzögerung mittels Schieberegister erfolgt.

**26.** Demodulator nach Anspruch 24 oder 25, dadurch gekennzeichnet, daß ein weiterer Zähler vorgesehen ist, der mit dem Vielfachen der Frequenz des Hilfsträgers getaktet wird und der mit einer Flanke des verzögerten hilfsträgerfrequenten Signals (B) gestartet und bei Erreichen des halben Vielfachens gestoppt wird, womit eine weitere Flanke des verzögerten hilfsträgerfrequenten Signals (B) abgeleitet wird.

**27.** Demodulator nach einem der vorhergehenden Ansprüche, dadurch gekennzeichnet, daß aus dem Rechtecksignal (ZD) mit Hilfe eines Frequenzphasendemodulators (321) in Abhängigkeit vom Vorzeichen der Phasendifferenz Zählimpulse abgeleitet werden, die einem ersten Zähler (322) und einem zweiten Zähler (323) zugeführt werden, daß die Zähler mit einer Frequenz, welche der doppelten Bittaktfrequenz entspricht, zurückgesetzt werden und daß die jeweils vor dem Zurücksetzen vorhandenen Zählerstände verglichen werden, worauf aus dem Vergleichsergebnis ein Datenimpulssignal abgeleitet wird.

**28.** Demodulator nach Ansrpuch 27, dadurch gekennzeichnet, daß ein Sprung im Datenimpulssignal nur erzeugt wird, wenn das Ausgangssignal des Komparators (326) innerhalb von zwei Perioden des Taktsignals mit doppelter Bittaktfrequenz den gleichen Wert aufweist.

**29.** Demodulator nach Anspruch 27 oder 28, dadurch gekennzeichnet, daß für den Frequenzphasendemodulator (321) ein Träger mit Hilfe eines Synchronsignals (SI) abgeleitet wird, dessen Flanken im wesentlichen in der Mitte der Impulse des Rechtecksignals beginnen, wobei Zählimpulse bis zu einem vorgegebenen Zählerstand gezählt werden, deren Frequenz während der Impulse des Rechtecksignals halb so groß wie während der Intervalle des Rechtecksignals ist.

**30.** Demodulator nach einem der Ansprüche 27 bis 29, dadurch gekennzeichnet, daß zur Erzeugung eines Taktsignals (BT) mit doppelter Bittaktfrequenz ein wiedergewonnener 57-kHz-Hilfsträger, der rechteckförmig ist, zur Demodulation des empfangenen oder des verzögerten hilfsträgerfrequenten Signals dient, wobei die Impulsflanken des demodulierten Signals zur Phasenbestimmung des Taktsignals (BT) benutzt werden.

31. Demodulator nach Anspruch 30, dadurch gekennzeichnet, daß phasenbestimmende Impulse nur in einem vorgegebenen Zeitbereich wirksam sind.

32. Demodulator nach Anspruch 31, dadurch gekennzeichnet, daß mit einem Zähler und mehreren Decodern von dem wiedergewonnenen Träger benachbarte Impulse abgeleitet werden und derjenige Impuls zur Erzeugung des doppelten Bittaktes (2BT) ausgewählt wird, zu dessen Zeit auch die phasenbestimmenden Impulse auftreten.

33. Demodulator nach Anspruch 32, dadurch gekennzeichnet, daß innerhalb der mit Decodern abgeleiteten Impulse mit einer Phasenfeinregelschaltung eine Mittelung der phasenbestimmenden Impulse zur feineren Phasenbestimmung des Taktsignals (BT) vorgenommen wird.

## Claims

1. Demodulator for radio data signals, the transmission of which is effected by phase-shift-keying a subcarrier, which can be suppressed or modulated with radio traffic service signals, wherein the signal of subcarrier frequency is transformed into a square wave signal and demodulation is effected by making use of phase relations of phase-shifted values of the square-wave signal, characterised in that the received and transformed signal is used as a first square wave signal (A), the phase relation of which can be determined and stored, in that a time-shifted square wave signal (B), which is synchronized with respect to the stored phase relation, is formed and in that the demodulation is effected by making use of relative phase relations of the two square wave signals (A, B).

2. Demodulator according to claim 1, characterised in that the received signal of subcarrier frequency is transformed into the first square wave signal (A) that has a constant pulse duty factor.

3. Demodulator according to claim 1 or 2, characterised in that the second square wave signal (B) is of the subcarrier frequency and is matched in terms of its phase relation at predetermined times to the phase relation of the first square wave signal (A), in that a resultant phase difference between the square wave signals is evaluated with respect to their time characteristic and their magnitude, and in that when a phase difference develops within a predetermined time span a load pulse (L) is derived that matches the phase relation of the second square wave signal (B) to the phase relation of the first square wave signal and forms an edge of the demodulated radio data signal.

4. Demodulator according to claim 3, characterised in that the phase difference between the square wave signals is effected by determining the pulse width of a third square wave signal (C) which is derived from the first and the second square wave signal with the aid of a logic circuit (5), preferably an exclusive-OR-circuit.

5. Demodulator according to claim 3 or 4, characterised in that in order to form the first square wave signal, the received signal of subcarrier frequency starts a counter (32) which is clocked by a frequency which is a multiple of, preferably 76 times, the frequency of the subcarrier and which is reset when half the multiple is attained.

6. Demodulator according to one of the claims 3 to 5, characterised in that a counter (7) is provided in order to form the second square wave signal (B), which counter is clocked by a frequency which is a multiple of, preferably 76 times, the frequency of the subcarrier and is reset when the multiple is attained, in that the counter count, which occurs during an edge of the first square wave signal within the period predetermined by the signal (L), is loaded into a memory (9), in that a comparator (11) is provided that compares the content of the memory (9) with the counter count and in that if both are identical, one edge of the second square wave signal (B) is produced and half a period of the subcarrier later the other edge of the second square wave signal (B) is produced.

7. Demodulator according to claim 6, characterised in that a further counter (13) is provided that is also clocked by the multiple of the subcarrier frequency, in that the output of the comparator (11) is connected to the set input of a flip-flop (12), the reset input of which is connected to the output of a decoder (14) which emits a signal when the further counter has attained a counter count corresponding to half the period, and in that an output of the flip-flop (12) is connected to the reset input of the further counter (13).

8. Demodulator according to one of the preceding claims, characterised in that the load pulse (L) is produced, furthermore, only if the phase difference between the first and the second square wave signals has been continuously reduced, as a function of a threshold value, within the time since the last load pulse.

9. Demodulator according to one of the preceding claims, characterised in that a load pulse is derived, furthermore, only if the sum of all the phase deviations between the first and the second square wave signal since the preceding load pulse has exceeded a predetermined threshold value.

10. Demodulator according to one of the preceding claims, characterised in that a clock pulse signal having the frequency of the subcarrier is derived from the quartz clock pulse signal of higher frequency by means of frequency division and in that by means of further frequency division a bit clock pulse signal for the demodulated radio data signal is produced.

11. Demodulator according to claim 10, characterised in that at least one shift register (23) is provided for the further frequency division, which shift register is set to a predetermined value at the time at which a data pulse signal derived from the load pulse (L) occurs.

12. Demodulator according to claim 11, characterised in that an output of the shift register (23) is connected to the input of a further shift register (24), the output of which supplies the bit clock pulse signal, in that the data pulse signal, which is derived from the load pulse (L), triggers a flip-flop (25), and in that the output signal of the flip-flop (25) and the bit clock pulse signal can be fed to a difference decoder (26).

13. Demodulator according to claim 1 or 2, characterised

- in that the received signal of subcarrier frequency is delayed by half a period of the bit clock pulse of the radio data signal;
- in that the phase difference between the received signal and the delayed signal of subcarrier frequency is measured; and
- in that a data pulse signal is derived that is at a first or a second level depending on the polarity sign of the measured phase difference.

14. Demodulator according to claim 13, characterised in that an oscillator, which produces a multiple of the frequency of the subcarrier, and a counter, which is reset at a counter count that corresponds to the multiple, are provided in order to produce the delayed signal of subcarrier frequency, in that the counter count for each edge of the square wave signal is delayed for half a bit clock pulse period, and in that an edge of the delayed signal (B) of subcarrier frequency is derived if the counter count corresponds to the delayed counter count.

15. Demodulator according to claim 14, characterised in that the delay is effected by means of shift registers.

16. Demodulator according to claim 14 or 15, characterised in that a further counter is provided that is clocked by the multiple of the frequency of the subcarrier and is started by means of an edge of the delayed signal (B) of subcarrier frequency and is stopped when half the multiple has been attained, whereby a further edge of the delayed signal (B) of subcarrier frequency is derived.

17. Demodulator according to one of the preceding claims, characterised in that the level of the data pulse signal is only changed if the phase of the signal (A) of subcarrier frequency has changed by a predetermined amount relative to the phase of the delayed signal (B) of subcarrier frequency.

18. Demodulator according to claim 17, characterised in that counters (245, 252; 246, 253) are provided for counting pulses (E, $\bar{E}$) using clock pulses of the oscillator (206) and in that the data pulse signal is set at the corresponding level when a respective predetermined counter count has been attained.

19. Demodulator according to claim 18, characterised in that clock pulse signals counted during the phase differences between the signal (A) of subcarrier frequency and the delayed signal (B) of subcarrier frequency are compared with a first reference value, separately for both polarity signs of the phase deviation, in that a further counter (252, 253) for each polarity sign of the phase deviation is clocked each time the first reference value is attained, and in that the counter counts of the further counters (252, 253) are compared with a further reference value and in that one of the levels of the data pulse signal is set as soon as one of the further counters (252, 253) attains the further reference value.

**20.** Demodulator according to one of the claims 17 to 19, characterised in that the counters (252, 253) are alternately released and reset by way of a flip-flop (257).

**21.** Demodulator according to claim 1 or 2, characterised

- in that the received signal of subcarrier frequency is delayed for half a period of the bit clock pulse of the radio data signal;
- in that the received signal and the delayed signal of subcarrier frequency are added vectorially;
- in that a square wave signal (ZD) is derived from the result of the vectorial addition, the phase of which signal depends upon the received signal and the delayed signal of subcarrier frequency;
- in that the subcarrier is recovered from the vectorially added signal; and
- in that a data pulse signal is derived from the square wave signal, which data pulse signal is at a first and a second level depending on the polarity sign of the measured phase difference between the square wave signal and the recovered subcarrier.

**22.** Demodulator according to claim 21, characterised in that the square wave signal is only evaluated for demodulation purposes if the amplitude of the vectorially added signal is sufficiently large.

**23.** Demodulator according to claim 21 or 22, characterised in that a signal having double the bit clock pulse frequency is derived from the recovered subcarrier and the undelayed signal (A) or the delayed signal (B) and is used for demodulation purposes.

**24.** Demodulator according to one of the claims 21 to 23, characterised in that an oscillator, which produces a multiple of the frequency of the subcarrier, and a counter, which is reset at a counter count that corresponds to the multiple, are provided in order to produce the delayed signal of subcarrier frequency, in that the counter count for each edge of the square wave signal is delayed for half a bit clock pulse period, and in that an edge of the delayed signal (B) of subcarrier frequency is derived if the counter count corresponds to the delayed counter count.

**25.** Demodulator according to claim 24 characterised in that the delay is effected by means of shift registers.

**26.** Demodulator according to claim 24 or 25 characterised in that a further counter is provided that is clocked by the multiple of the frequency of the subcarrier and is started by means of an edge of the delayed signal (B) of subcarrier frequency and is stopped when half the multiple has been attained, whereby a further edge of the delayed signal (B) of subcarrier frequency is derived.

**27.** Demodulator according to one of the preceding claims, characterised in that counting pulses are derived from the square wave signal (ZD), with the aid of a frequency/phase demodulator (321), as a function of the polarity sign of the phase difference, and are fed to a first counter (322) and a second counter (323), in that the counters are reset by a frequency corresponding to double the bit clock pulse frequency and in that the counter counts existing before each reset are compared, whereupon a data pulse signal is derived from the result of comparison.

**28.** Demodulator according to claim 27, characterised in that a sudden change in the data pulse signal is only produced if the output signal of the comparator (326) has the same value within two periods of the clock pulse signal with double bit clock pulse frequency.

**29.** Demodulator according to claim 27 or 28, characterised in that a carrier for the frequency/phase demodulator (321) is derived with the aid of a sync signal (SI), the edges of which start essentially in the middle of the pulses of the square wave signal, in which case counting pulses are counted up to a predetermined counter count and have a frequency during the pulses of the square wave signal that is half as great as the frequency during the gaps in the square wave signal.

**30.** Demodulator according to one of the claims 27 to 29, characterised in that in order to produce a clock pulse signal (BT) having double bit clock pulse frequency, a recovered 57-kHz subcarrier of square-wave form is used to demodulate the received signal or the delayed signal of subcarrier frequency, the pulse edges of the demodulated signal being used to determine the phase of the clock pulse signal (BT).

**31.** Demodulator according to claim 30, characterised in that phase-determining pulses are only effective within a predetermined time range.

**32.** Demodulator according to claim 31, characterised in that adjacent pulses are derived from the recovered carrier by means of a counter and a plurality of decoders, and the pulse, at the time of which the phase-determining pulses also occur, is selected in order to produce the double bit clock pulse (2BT).

**33.** Demodulator according to claim 32, characterised in that during the pulses derived by means of the decoders by means of a fine phase control circuit the mean of the phase-determining pulses is taken for the purposes of comparatively fine phase-determination of the clock pulse signal (BT).

**Revendications**

**1.** Démodulateur pour signaux de données radio, dont la transmission a lieu par manipulation de phase d'une porteuse auxiliaire, qui peut être modulée avec des signaux radio de télécommunication ou affaiblie, dans lequel le signal à la fréquence de la porteuse auxiliaire est transformé en un signal rectangulaire et la démodulation a lieu par évaluation des phases de valeurs déphasées du signal rectangulaire, caractérisé en ce que le signal reçu et transformé est utilisé comme premier signal rectangulaire (A) dont la phase peut-être déterminée et mise en mémoire, en ce qu'un signal rectangulaire (B) décalé temporellement, synchronisé par rapport à la phase mise en mémoire est élaboré, et en ce que la démodulation résulte de l'exploitation de phases relatives des deux signaux rectangulaires (A, B).

**2.** Démodulateur selon la revendication 1, caractérisé en ce que le signal reçu ayant la fréquence de la porteuse auxiliaire est transformé en le premier signal rectangulaire (A) avec un rapport d'échantillonnage constant.

**3.** Démodulateur selon la revendication 1 ou 2, caractérisé en ce que le deuxième signal rectangulaire (B) présente la fréquence de la porteuse auxiliaire, et est mis en concordance, pour sa phase, à des instants déterminés, avec la phase du premier signal rectangulaire (A), en ce qu'une différence de phase qui en résulte entre les signaux rectangulaires est évaluée en ce qui concerne son allure temporelle et sa valeur, et en ce qu'en cas d'apparition d'une différence de phase à l'intérieur d'un intervalle de temps prédéterminé, il est émis une impulsion de charge (L) qui amène la phase du second signal rectangulaire (B) en concordance avec la phase du premier signal rectangulaire et constitue un flanc du signal de données radio démodulées.

**4.** Démodulateur selon la revendication 3, caractérisé en ce que la différence de phase entre les signaux rectangulaires est faite par détermination de la largeur d'impulsion d'un troisième signal rectangulaire (C), qui est obtenu à partir du premier et du deuxième signal rectangulaire au moyen d'un circuit logique (5), de préférence un circuit OU exclusif.

**5.** Démodulateur selon la revendication 3 ou 4, caractérisé en ce que pour l'élaboration du premier signal rectangulaire, le signal reçu ayant la fréquence de la porteuse auxiliaire lance un compteur (32) cadencé par une fréquence qui est un multiple, de préférence par 76, de la fréquence de la porteuse auxiliaire, et qui est remis à zéro lorsque est atteinte la moitié du multiple.

**6.** Démodulateur selon l'une des revendications 3 à 5, caractérisé en ce que pour l'élaboration du deuxième signal rectangulaire (B), il est prévu un compteur (7) qui est cadencé à une fréquence qui est un multiple, de préférence par 76, de la fréquence de la porteuse auxiliaire et qui est remis à zéro lorsque le multiple est atteint, en ce que l'état de compteur qui s'établit pendant un flanc du premier signal rectangulaire à l'intérieur de la durée prédéterminée par le signal (L) est chargé dans une mémoire (9), en ce qu'il est prévu un comparateur (11) qui compare le contenu de la mémoire (9) avec l'état de comptage, et en ce qu'en cas d'égalité sont produits un flanc du deuxième signal rectangulaire (B) puis, une demi-période de la porteuse auxiliaire plus tard, l'autre flanc du deuxième signal rectangulaire (B).

**7.** Démodulateur selon la revendication 6, caractérisé en ce qu'il est prévu un autre compteur (13), qui est également cadencé au multiple de la fréquence de la porteuse auxiliaire, en ce que la sortie du comparateur (11) est reliée avec l'entrée d'activation d'une bascule (12), dont l'entrée de désactivation est raccordée à la sortie d'un décodeur (14) qui fournit un signal lorsque l'autre compteur a atteint un état de comptage correspondant à la demi-période, et en ce que la sortie de la bascule (12) est reliée avec l'entrée de remise à zéro de l'autre compteur (13).

**8.** Démodulateur selon l'une des revendications précédentes, caractérisé en ce que l'impulsion de charge (L) n'est en outre produite que lorsque la différence de phase entre le premier et le second signal rectangulaire a décru sans interruption en fonction d'une valeur de seuil depuis la dernière impulsion de charge.

9. Démodulateur selon l'une des revendications précédentes, caractérisé en ce qu'en outre une impulsion de charge n'est produite que lorsque la somme de toutes les déviations de phases entre le premier et de deuxième signal rectangulaire a franchi une valeur de seuil prédéterminée depuis l'impulsion de charge passée.

10. Démodulateur selon l'une des revendications précédentes, caractérisé en ce qu'un signal de cadencement ayant la fréquence de la porteuse auxiliaire est tiré du signal de cadencement du quartz à fréquence plus élevée par division de fréquence et en ce qu'un signal de cadencement de bit est produit par division supplémentaire de la fréquence pour le signal de données radio démodulé.

11. Démodulateur selon la revendication 10, caractérisé en ce que pour la division supplémentaire de fréquence il est prévu au moins un registre à décalage (23) qui est mis à une valeur prédéterminée à l'instant où survient un signal d'impulsion de données issu de l'impulsion de charge (L).

12. Démodulateur selon la revendication 11, caractérisé en ce qu'une sortie du registre à décalage (23) est reliée avec l'entrée d'un autre registre à décalage (24) dont la sortie véhicule le signal de cadencement de bit, en ce que le signal d'impulsion de données issu de l'impulsion de charge (L) déclenche une bascule (25), et en ce que le signal de sortie de la bascule (25) et le signal de cadencement de bit peuvent être conduits à un décodeur à différence (26).

13. Démodulateur selon la revendication 1 ou 2, caractérisé en ce que

 - le signal reçu ayant la fréquence de la porteuse auxiliaire est retardé d'une demi-période de la fréquence de bit du signal de données radio,
 - en ce que la différence de phase entre le signal reçu ayant la fréquence de la porteuse auxiliaire et le signal retardé est mesurée et
 - il en est tiré un signal d'impulsion de données, qui prend un premier ou un second niveau en fonction du signe de la différence de phase mesurée.

14. Démodulateur selon la revendication 13, caractérisé en ce que pour la production du signal retardé ayant la fréquence de la porteuse auxiliaire, il est prévu un oscillateur qui produit un multiple de la fréquence de la porteuse auxiliaire et un compteur qui est remis à zéro lorsque l'état de comptage correspond au multiple, en ce que l'état de comptage qui prévaut lors de chaque flanc du signal rectangulaire est décalé d'une demi-période de cadencement de bit, et en ce qu'un flanc du signal retardé ayant la fréquence de la porteuse auxiliaire (B) est émis lorsque l'état de comptage correspond à l'état de comptage retardé.

15. Démodulateur selon la revendication 14, caractérisé en ce que le retardement est réalisé par registre à décalage.

16. Démodulateur selon la revendication 14 ou 15, caractérisé en ce qu'il est prévu un autre compteur, qui est cadencé au multiple de la fréquence de la porteuse auxiliaire et qui est lancé avec un flanc du signal retardé ayant la fréquence de la porteuse auxiliaire (B) et stoppé lorsque le demi-multiple est atteint, auquel cas un autre flanc du signal retardé ayant la fréquence de la porteuse auxiliaire (B) est émis.

17. Démodulateur selon l'une des revendications précédentes, caractérisé en ce que le niveau du signal d'impulsion de données n'est modifié que lorsque la phase du signal ayant la fréquence de la porteuse auxiliaire (A) a varié d'une quantité prédéterminée par rapport à la phase du signal retardé ayant la fréquence de la porteuse auxiliaire (B).

18. Démodulateur selon la revendication 17, caractérisé en ce qu'il est prévu des compteurs (245, 252; 246, 253) pour compter des impulsions (E, E) avec des impulsions de cadencement de l'oscillateur (206), et en ce que chaque fois qu'un état de comptage prédéterminé est atteint le signal d'impulsion de données est mis au niveau correspondant.

19. Démodulateur selon la revendication 18, caractérisé en ce que les signaux de cadencement comptés pendant les différences de phases entre le signal ayant la fréquence de la porteuse auxiliaire (A) et le signal retardé ayant la fréquence de la porteuse auxiliaire (B) sont comparés séparément pour les deux signes du décalage de phase avec une première valeur de consigne, en ce que chaque fois que la première valeur de consigne est atteinte, un autre compteur (252, 253), un par signe du décalage de phase, est cadencé, en ce que les états de comptage des autres compteurs (252, 253) sont comparés avec une autre valeur de consigne, et en ce que l'un des niveaux du signal d'impulsion de données est établi dès que l'un des autres compteurs (252, 253) atteint l'autre valeur de consigne.

20. Démodulateur selon l'une des revendications 17 à 19, caractérisé en ce que les compteurs (252, 253) sont alternativement libérés et remis à zéro par l'intermédiaire d'une bascule (257).

21. Démodulateur selon la revendication 1 ou 2, caractérisé

- en ce que le signal reçu ayant la fréquence de la porteuse auxiliaire est retardé d'une demi-période de la cadence de bit du signal de données radio,
- en ce que les signaux reçu et retardé ayant la fréquence de la porteuse auxiliaire sont additionnés vectoriellement,
- en ce qu'il est tiré du résultat de l'addition vectorielle un signal rectangulaire (ZD) dont la phase dépend du signal reçu et du signal retardé ayant la fréquence de la porteuse auxiliaire,
- en ce que la porteuse auxiliaire est reconstituée à partir du signal additionné vectoriellement, et
- en ce qu'il est tiré du signal rectangulaire un signal d'impulsion de données qui prend un premier et un deuxième niveau en fonction du signe de la différence de phase mesurée entre le signal rectangulaire et la porteuse auxiliaire reconstituée.

22. Démodulateur selon la revendication 21, caractérisé en ce que le signal rectangulaire n'est évalué en vue de la démodulation que lorsque l'amplitude du signal additionné vectoriellement est suffisamment grande.

23. Démodulateur selon la revendication 21 ou 22, caractérisé en ce qu'un signal ayant une fréquence double de la fréquence de cadencement de bit est tiré de la porteuse auxiliaire reconstituée et du signal non retardé (A) ou du signal retardé (B), et utilisé pour la démodulation.

24. Démodulateur selon l'une des revendications 21 à 23, caractérisé en ce que pour la production du signal retardé ayant la fréquence de la porteuse auxiliaire, il est prévu un oscillateur qui produit un multiple de la fréquence de la porteuse auxiliaire et un compteur qui est remis à zéro lorsque l'état de contage correspond au multiple, en ce que l'état de comptage qui prévaut lors de chaque flanc du signal rectangulaire est décalé d'une demi-période de cadencement de bit, et en ce qu'un flanc du signal retardé ayant la fréquence de la porteuse auxiliaire (B) est émis lorsque l'état de comptage correspond à l'état de comptage retardé.

25. Démodulateur selon la revendication 24, caractérisé en ce que le retardement est réalisé par registre à décalage.

26. Démodulateur selon la revendication 24 ou 25, caractérisé en ce qu'il est prévu un autre compteur, qui est cadencé au multiple de la fréquence de la porteuse auxiliaire et qui est lancé avec un flanc du signal retardé ayant la fréquence de la porteuse auxiliaire (B) et stoppé lorsque le demi-multiple est atteint, auquel cas un autre flanc du signal retardé ayant la fréquence de la porteuse auxiliaire (B) est émis.

27. Démodulateur selon l'une des revendications précédentes, caractérisé en ce que des impulsions de comptage sont tirées du signal rectangulaire (ZD) à l'aide d'un démodulateur fréquence phase (321) en fonction du signe de la différence de phase, lesquelles sont conduites à un premier compteur (322) et à un deuxième compteur (323), en ce que les compteurs sont remis à zéro avec une fréquence correspondant au double de la fréquence de cadencement de bit, et en ce que les états de comptage présents avant chaque remise à zéro sont chaque fois comparés, à la suite de quoi un signal d'impulsion de données est tiré du résultat de la comparaison.

28. Démodulateur selon la revendication 27, caractérisé en ce qu'un saut dans le signal d'impulsion de données n'est produit que lorsque le signal de sortie du comparateur (326) présente la même valeur à l'intérieur de deux périodes du signal de cadencement dont la fréquence est double de la fréquence de cadencement de bit.

29. Démodulateur selon la revendication 27 ou 28, caractérisé en ce que pour le démodulateur fréquence phase (321) est extraite une porteuse à l'aide d'un signal synchrone (SI) dont les flancs commencent sensiblement au milieu des impulsions du signal rectangulaire, des impulsions de comptage étant comptées jusqu'à un état de comptage prédéterminé, la fréquence des impulsions de comptage étant moitié moins grande pendant les impulsions du signal rectangulaire que pendant les intervalles du signal rectangulaire.

**30.** Démodulateur selon l'une des revendications 27 à 29, caractérisé en ce que pour la production d'un signal de cadencement (BT) ayant une fréquence double de la fréquence de cadencement de bit, une porteuse auxiliaire à 57 kHz reconstituée, qui est rectangulaire, sert à la démodulation du signal reçu ou retardé ayant la fréquence de la porteuse auxiliaire, les flancs d'impulsion du signal démodulé étant utilisés pour déterminer la phase du signal de cadencement (BT).

**31.** Démodulateur selon la revendication 30, caractérisé en ce que les impulsions déterminatrices de phase n'ont d'effet que dans une plage de temps prédéterminée.

**32.** Démodulateur selon la revendication 31, caractérisé en ce qu'avec un compteur et plusieurs décodeurs, des impulsions voisines sont extraites de la porteuse reconstituée, et l'impulsion choisie pour produire la cadence (2BT) double de celle des bits est celle à l'instant de laquelle les impulsions déterminatrices de phase apparaissent également.

**33.** Démodulateur selon la revendication 32, caractérisé en ce qu'à l'intérieur des impulsions extraites avec des décodeurs une moyenne des impulsions déterminatrices de phases est faite avec un circuit de régulation fine de la phase pour une détermination plus fine de la phase du signal de cadencement (BT).

Fig. 1

EP 0 627 138 B1

Fig. 2

Fig. 3

## Fig. 4

Fig. 5

Fig. 6

Fig. 7

Fig. 8

EP 0 627 138 B1

Fig. 9

Fig. 10

Fig. 11

Fig. 12

Fig. 13

Fig. 14

Fig. 15

Fig. 16

Fig. 17

EP 0 627 138 B1

Fig. 18

Fig. 19

318 → 422 — | CL  0,1, 2... | 421
423 [n+0]  424 [n+1]  425 [n+2]
426
427 | CL  0,1, 2... |
428 [A] ....... [H]
432
433 → 324,335
434
320 → 429 — | 430 | —J→ | 431 | —I→

EP 0 627 138 B1

Fig. 20

Fig. 21

Fig. 22